# EUROPEAN PATENT APPLICATION

(11) **EP 2 224 496 A1**
(43) Date of publication of application: **01.09.2010**
(21) Application number: 08851106.8
(22) Date of filing: 11.11.2008
(51) Int. Cl.: H01L 31/042, H01L 31/04

(54) **WIRING MEMBER BETWEEN ELEMENTS, PHOTOELECTRIC CONVERSION ELEMENT, AND PHOTOELECTRIC CONVERSION ELEMENT CONNECTING BODY AND PHOTOELECTRIC CONVERSION MODULE USING THE WIRING MEMBER BETWEEN ELEMENTS AND THE PHOTOELECTRIC CONVERSION ELEMENT**

(30) Priority: 22.11.2007 JP 2007303274
(71) Applicant: Sharp Kabushiki Kaisha, Osaka-shi Osaka 545-8522 (JP)
(72) Inventor: The designation of the inventor has not yet been filed
(74) Representative: Müller - Hoffmann & Partner
(86) International application number: PCT/JP2008/070475
(87) International publication number: WO 2009/066583

(57) **Abstract**

An interconnector (20) includes an extending portion (21) extending in one direction and a connection portion (22) fixed to an n electrode (8) or a p electrode (9) formed on a cell substrate (11) of a photoelectric conversion element (1) for connection to this electrode (8, 9). The connection portion (22) is formed in a comb shape so as to protrude from the extending portion (21) in a direction substantially orthogonal to the one direction. Though the extending portion (21) is in contact with the cell substrate (11), it is not fixed to the cell substrate. By not fixing the extending portion (21) to the cell substrate (11), stress involved with heat shrinkage can be released and a degree of freedom in arrangement of the n electrode (8) and the p electrode (9) formed on the photoelectric conversion element (1) can be enhanced.

## Description

### Element Interconnection Member, Photoelectric Conversion Element and a Series of Photoelectric Conversion Elements Including the Same, and Photoelectric Conversion Module

### TECHNICAL FIELD

The present invention relates to an element interconnection member, a photoelectric conversion element and a series of photoelectric conversion elements including the same, as well as a photoelectric conversion module, and particularly to an element interconnection member connecting element-formed substrates to one another each having a prescribed element main body formed thereon, a photoelectric conversion element in which such an element interconnection member is connected to an element-formed substrate, a series of photoelectric conversion elements obtained by electrically connecting a plurality of photoelectric conversion element substrates to one another through a plurality of element interconnection members, and a photoelectric conversion module including such a series of photoelectric conversion elements.

### BACKGROUND ART

Solar cells having electrodes on opposing surfaces are dominant among currently mass-produced solar cells. In a solar cell having electrodes on both surfaces, an n electrode is formed on a surface (a light-receiving surface) of a cell substrate and a p electrode is formed on a back surface. The n electrode formed on the light-receiving surface is indispensable for extracting to the outside, a current generated as solar rays are incident on the cell substrate. In a portion (an area) of the cell substrate where the n electrode serving as an extraction electrode is arranged, however, the n electrode casts shadow and solar rays are not incident thereon, which leads to no current generation.

A back contact solar cell in which an extraction electrode is not formed on a light-receiving surface side but an extraction electrode is formed on a back surface side has been developed. Exemplary documents disclosing such a back contact solar cell include United States Patent No. 4927770 (Patent Document 1) and J. H. Bultman et al., "Interconnection through vias for improved efficiency and easy module manufacturing of crystalline silicon solar cells," Solar Energy Materials & Solar Cells 65(2001) 339-345 (Non-Patent Document 1). In particular, in a cell substrate of a solar cell proposed in Non-Patent Document 1, a through hole is formed from a light-receiving surface side through a silicon substrate forming the cell substrate to a back surface side and an extraction electrode is formed through the through hole on the back surface side. Therefore, on the back surface side of the cell substrate, both of a p electrode and an n electrode serving as an extraction electrode are present.

In order to form a solar cell string by connecting individual cell substrates to one another, an interconnection substrate in which a prescribed interconnection pattern based on an arrangement pattern of p electrodes and n electrodes is formed is employed. A similar back contact solar cell is proposed also in Japanese Patent Laying-Open No. 2007-19334 (Patent Document 2) and Japanese Patent Laying-Open No. 2005-340362 (Patent Document 3), and individual cell substrates are connected to one another through interconnection substrates in which an interconnection pattern based on an arrangement pattern of p electrodes and n electrodes is formed.

Thus, in a conventional back contact solar cell, an interconnection substrate in which a prescribed arrangement pattern based on an arrangement pattern of p electrodes and n electrodes is formed has been employed for forming a solar cell string by connecting individual cell substrates to one another.

On the other hand, since both of n electrodes and p electrodes are formed on the back surface side of the individual cell substrates, an interconnection pattern is more complicated than in an example where only one type of electrode is formed, in terms of an interconnection pattern of an interconnection substrate. Therefore, registration accuracy of an interconnection substrate with respect to a cell substrate is required in order to avoid electrical short-circuiting due to contact of an interconnection pattern with an electrode to which it should basically not be connected, and assembly disadvantageously becomes complicated. In addition, since an interconnection pattern is formed on a surface of an interconnection substrate, contact of an interconnection pattern to all electrodes to be connected has not been ensured and poor contact has sometimes occurred.

In order to solve such problems, a solar cell string in which cell substrates are connected to one another through interconnectors has been proposed. In a solar cell string of this type, interconnectors are fixed and electrically connected to a plurality of n electrodes and p electrodes formed on a back surface of a cell substrate, respectively.
Patent Document 1: United States Patent No. 4927770
Patent Document 2: Japanese Patent Laying-Open No. 2007-19334
Patent Document 3: Japanese Patent Laying-Open No. 2005-340362
Non-Patent Document 1: J. H. Bultman et al., "Interconnection through vias for improved efficiency and easy module manufacturing of crystalline silicon solar cells," Solar Energy Materials & Solar Cells 65(2001) 339-345.

### DISCLOSURE OF THE INVENTION

### PROBLEMS TO BE SOLVED BY THE INVENTION

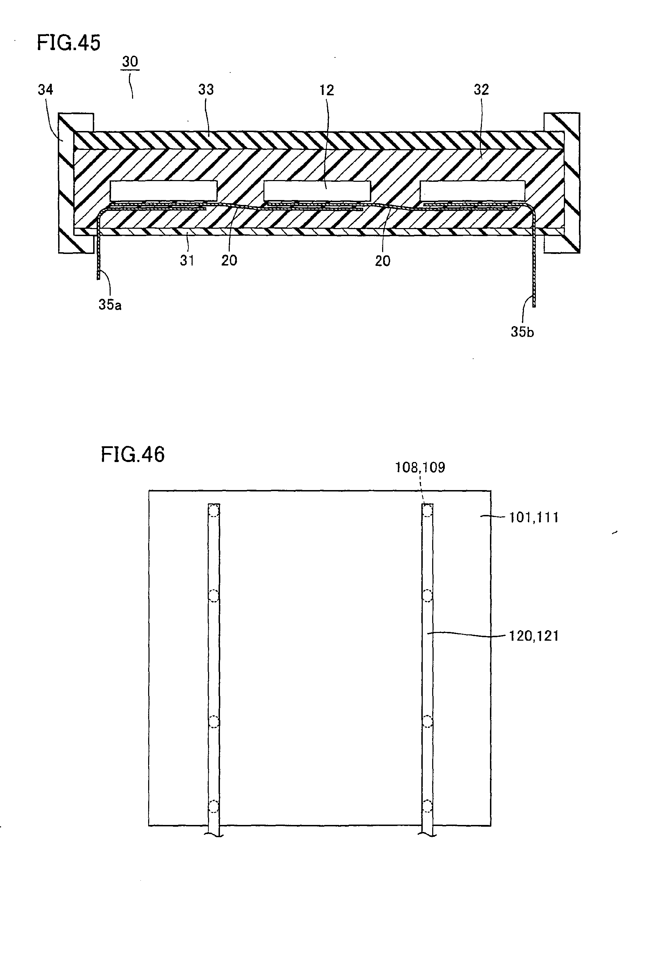

The conventional solar cell string obtained by connection through the interconnectors, however, has suffered from the following problems. As shown in Fig. 46, a plurality of n electrodes and p electrodes are formed along one direction on a back surface of a cell substrate 111 of a conventional solar cell string. Plate-shaped, linearly extending interconnectors 120 and 121 are fixed and electrically connected to the n electrodes and the p electrodes, respectively.

Interconnectors 120 and 121 are different in coefficient of thermal expansion from cell substrate 111. Therefore, difference in coefficient of thermal expansion causes stress between interconnectors 120 and 121 and a p electrode 109 or an n electrode 108, depending on a manufacturing process or an environment after installation, and poor connection or breakage of a solar cell has been likely. In addition, in linear interconnectors 120 and 121, arrangement of n (p) electrodes 108, 109 formed on cell substrate 111 is limited to specific arrangement and a degree of freedom in arranging electrodes has been limited.

The present invention was made to solve the above-described problems, and one object of the present invention is to provide an element interconnection member improving poor connection to an electrode by relaxing stress involved with connection to an electrode formed on a photoelectric conversion element and achieving a higher degree of freedom in arranging electrodes. Another object is to provide a photoelectric conversion element to which such an element interconnection member is connected. Yet another object is to provide a series of photoelectric conversion elements obtained by connecting a plurality of photoelectric conversion elements to one another through the element interconnection members. Still another object is to provide a photoelectric conversion module including such a series of photoelectric conversion elements.

### MEANS FOR SOLVING THE PROBLEMS

An element interconnection member according to the present invention is an element interconnection member for electrically connecting one element-formed substrate and another element-formed substrate to each other, each having a prescribed element main body and a plurality of electrodes formed thereon, and the element interconnection member includes an extending portion, a first connection portion, and a second connection portion. The extending portion extends in a prescribed direction based on arrangement relation of one element-formed substrate and another element-formed substrate. The first connection portion is formed in a comb shape so as to protrude from the extending portion in another direction intersecting the prescribed direction and fixed and electrically connected to a prescribed electrode of the plurality of electrodes on one element-formed substrate. The second connection portion is formed in a comb shape so as to protrude from the extending portion in yet another direction intersecting the prescribed direction and fixed and electrically connected to a prescribed electrode of the plurality of electrodes on another element-formed substrate.

According to this feature, the first connection portion and the second connection portion of the element interconnection member are formed in a comb shape relative to the extending portion, so that stress involved with heat shrinkage can be released and poor electrical connection between the first connection portion and a prescribed electrode can be improved and poor electrical connection between the second connection portion and a prescribed electrode can be improved. In addition, by adjusting a length of the first connection portion and the second connection portion or adjusting a position of the first connection portion and the second connection portion in the extending portion, a degree of freedom of a position of an electrode on an element-formed substrate to which the element interconnection member is fixed can be enhanced.

In order to effectively relax stress involved with heat shrinkage, preferably, the extending portion includes a portion not fixed to one element-formed substrate and another element-formed substrate.

In addition, preferably, the first connection portion is fixed to the prescribed electrode and the second connection portion is fixed to the prescribed electrode while a surface of one element-formed substrate where the prescribed electrode is formed and a surface of another element-formed substrate where the prescribed electrode is formed face in an identical direction.

Thus, one element-formed substrate and another element-formed substrate can electrically be connected to each other through the element interconnection member with their surfaces being on the same side.

In addition, preferably, the extending portion includes a first extending portion extending in a first direction as the prescribed direction, a second extending portion connected to the first extending portion so as to extend in a second direction intersecting the first direction, and a third extending portion connected to the first extending portion so as to extend in a third direction opposite to the second direction, the first connection portion is provided in the second extending portion, and the second connection portion is provided in the third extending portion.

Thus, the second extending portion where the first connection portion is provided and the third extending portion where the second connection portion is provided are continuous to each other through the first extending portion, so that a plurality of prescribed electrodes can readily electrically be connected through one element interconnection member.

A photoelectric conversion element according to the present invention includes a photoelectric conversion substrate, a first electrode and a second electrode, and an element interconnection member. The photoelectric conversion substrate has a first main surface and a second main surface, has the first main surface as a light-receiving surface, and has a photoelectric conversion element main body formed thereon. The first electrode and the second electrode are each formed on the second main surface of the photoelectric conversion substrate as a terminal of the photoelectric conversion element main body. The element interconnection member has an extending portion extending in a prescribed direction and a connection portion formed in a comb shape so as to protrude from the extending portion in a direction intersecting the prescribed direction, the connection portion being fixed to the first electrode.

According to this feature, the connection portion of the element interconnection member fixed to the first electrode on the photoelectric conversion substrate is formed in a comb shape relative to the extending portion so that stress involved with heat shrinkage can be released and poor electrical connection between the connection portion and the first electrode or the second electrode can be improved.

A series of photoelectric converters according to the present invention includes a plurality of photoelectric conversion substrates, a first electrode and a second electrode, and a plurality of element interconnection members. The plurality of photoelectric conversion substrates each have a first main surface and a second main surface, each have the first main surface as a light-receiving surface, and each have a photoelectric conversion element main body formed thereon. The first electrode and the second electrode are each formed on the second main surface of each of the plurality of photoelectric conversion substrates as a terminal of the photoelectric conversion element. The plurality of element interconnection members each have an extending portion extending in a prescribed direction and a first connection portion and a second connection portion each formed in a comb shape so as to protrude from the extending portion in a direction intersecting the prescribed direction, and the first connection portion is fixed to the first electrode on one photoelectric conversion substrate and the second connection portion is fixed to the second electrode on another photoelectric conversion substrate adjacent to one photoelectric conversion substrate among the plurality of photoelectric conversion substrates, thereby the plurality of photoelectric conversion substrates being electrically connected to one another.

According to this feature, the first connection portion fixed to the first electrode on one photoelectric conversion substrate among the plurality of photoelectric conversion substrates is formed to protrude in a comb shape relative to the extending portion and the second connection portion fixed to the second electrode on another photoelectric conversion substrate adjacent to one photoelectric conversion substrate is formed to protrude in a comb shape relative to the extending portion, so that stress involved with heat shrinkage can be released and poor electrical connection between each connection portion and the first electrode or the second electrode can be improved. In addition, by adjusting a length of the first connection portion and the second connection portion or adjusting a position of the first connection portion and the second connection portion in the extending portion, a degree of freedom of a position of the first electrode and the second electrode on a photoelectric conversion substrate to which the element interconnection member is fixed can be enhanced.

In addition, preferably, the first connection portion of one element interconnection member of the plurality of element interconnection members, that is fixed to the first electrode on one photoelectric conversion substrate and the second connection portion of another element interconnection member of the plurality of element interconnection members, that is fixed to the second electrode on one photoelectric conversion substrate are disposed to face each other.

Thus, each element interconnection member can be connected to the photoelectric conversion substrate while avoiding contact between one element interconnection member and another element interconnection member in an example where the first electrode and the second electrode are linearly arranged or an example where an interval between the first electrode and the second electrode is relatively short.

Another element interconnection member according to the present invention is an element interconnection member for electrically connecting one element-formed substrate and another element-formed substrate to each other, each having a prescribed element main body and a plurality of electrodes formed thereon, and the element interconnection member includes a zigzag-shaped extending portion extending in a prescribed direction based on arrangement relation of one element-formed substrate and another element-formed substrate.

According to this feature, the extending portion is in a zigzag shape so that stress involved with heat shrinkage can be released and poor electrical connection between the extending portion and a prescribed electrode can be improved.

The extending portion may be in such a zigzag shape as bending a straight line or may be in a curved zigzag shape.

Another photoelectric conversion element according to the present invention includes a photoelectric conversion substrate, a first electrode and a second electrode, and an element interconnection member. The photoelectric conversion substrate has a first main surface and a second main surface, has the first main surface as a light-receiving surface, and has a photoelectric conversion element main body formed thereon. The first electrode and the second electrode are each formed on the second main surface of the photoelectric conversion substrate as a terminal of the photoelectric conversion element main body. The element interconnection member has a zigzag-shaped extending portion extending in a prescribed direction, a prescribed portion in the extending portion being fixed to the first electrode.

According to this feature, the extending portion of the element interconnection member fixed to the first electrode on the photoelectric conversion substrate is in a zigzag shape so that stress involved with heat shrinkage can be released and poor electrical connection between the extending portion and the first electrode or the second electrode can be improved.

Another series of photoelectric converters according to the present invention includes a plurality of photoelectric conversion substrates, a first electrode and a second electrode, and a plurality of element interconnection members. The plurality of photoelectric conversion substrates each have a first main surface and a second main surface, each have the first main surface as a light-receiving surface, and each have a photoelectric conversion element main body formed thereon. The first electrode and the second electrode are each formed on the second main surface of each of the plurality of photoelectric conversion substrates as a terminal of the photoelectric conversion element. The plurality of element interconnection members each have a zigzag-shaped extending portion extending in a prescribed direction, and a prescribed portion of the extending portion is fixed to the first electrode on one photoelectric conversion substrate and another prescribed portion of the extending portion is fixed to the second electrode on another photoelectric conversion substrate adjacent to one photoelectric conversion substrate among the plurality of photoelectric conversion substrates, thereby the plurality of photoelectric conversion substrates being electrically connected to one another.

According to this feature, the extending portion fixed to the first electrode on one photoelectric conversion substrate among the plurality of photoelectric conversion substrates and fixed to the second electrode on another photoelectric conversion substrate adjacent to one photoelectric conversion substrate is in a zigzag shape so that stress involved with heat shrinkage can be released and poor electrical connection between each extending portion and the first electrode or the second electrode can be improved.

A photoelectric conversion module according to the present invention includes the series of photoelectric conversion elements above. Therefore, as described above, stress involved with heat shrinkage can be released in this photoelectric conversion module and poor electrical connection between each connection portion and the first electrode or the second electrode can be improved.

### BRIEF DESCRIPTION OF THE DRAWINGS

Fig. 1 is a plan view showing a structure of an interconnector and a photoelectric conversion element including the interconnector according to each embodiment of the present invention.
Fig. 2 is a cross-sectional view showing a structure of a cell substrate of the photoelectric conversion element according to a first embodiment of the present invention.
Fig. 3 is a plan view showing arrangement of electrodes on a back surface opposite to a light-receiving surface of the cell substrate in this embodiment.
Fig. 4 is a plan view showing arrangement of light-receiving-surface electrodes on the light-receiving surface of the cell substrate in this embodiment.
Fig. 5 is a plan view showing a structure of the interconnector electrically connecting the photoelectric conversion elements to each other in this embodiment.
Fig. 6 is a plan view showing a structure of a series of photoelectric conversion elements connected to one another through the interconnectors in this embodiment.
Fig. 7 is a cross-sectional view showing one step in a method of manufacturing a photoelectric conversion element in this embodiment.
Fig. 8 is a cross-sectional view showing a step performed subsequent to the step shown in Fig. 7 in this embodiment.
Fig. 9 is a cross-sectional view showing a step performed subsequent to the step shown in Fig. 8 in this embodiment.
Fig. 10 is a cross-sectional view showing a step performed subsequent to the step shown in Fig. 9 in this embodiment.
Fig. 11 is a cross-sectional view showing a step performed subsequent to the step shown in Fig. 10 in this embodiment.
Fig. 12 is a perspective view showing one step performed subsequent to the step shown in Fig. 11 in this embodiment.
Fig. 13 is a perspective view showing another step performed subsequent to the step shown in Fig. 11 in this embodiment.
Fig. 14 is a first plan view for illustrating a function and effect of the present interconnector in this embodiment.
Fig. 15 is a first cross-sectional view corresponding to Fig. 14 for illustrating a function and effect of the present interconnector in this embodiment.
Fig. 16 is a second plan view for illustrating a function and effect of the present interconnector in this embodiment.
Fig. 17 is a second cross-sectional view corresponding to Fig. 16 for illustrating a function and effect of the present interconnector in this embodiment.
Fig. 18 is a first plan view for illustrating a function and effect of an interconnector according to a comparative example.
Fig. 19 is a first cross-sectional view corresponding to Fig. 18 for illustrating a function and effect of the interconnector according to the comparative example.
Fig. 20 is a second cross-sectional view for illustrating a function and effect of the interconnector according to the comparative example.
Fig. 21 is a plan view showing a first variation of arrangement of electrodes on the back surface of the cell substrate in this embodiment.
Fig. 22 is a plan view showing a second variation of arrangement of electrodes on the back surface of the cell substrate in this embodiment.
Fig. 23 is a plan view showing a third variation of arrangement of electrodes on the back surface of the cell substrate in this embodiment.
Fig. 24 is a plan view showing a fourth variation of arrangement of electrodes on the back surface of the cell substrate in this embodiment.
Fig. 25 is a plan view showing a variation of arrangement of light-receiving-surface electrodes on the cell substrate in this embodiment.
Fig. 26 is a plan view showing one step in a method of manufacturing an interconnector in this embodiment.
Fig. 27 is a plan view showing a step performed subsequent to the step shown in Fig. 26 in this embodiment.
Fig. 28 is a plan view showing a first variation of the interconnector in this embodiment.
Fig. 29 is a plan view showing a second variation of the interconnector in this embodiment.
Fig. 30 is a plan view showing a series of photoelectric conversion elements connected to one another through the interconnectors shown in Fig. 29 in this embodiment.
Fig. 31 is a plan view showing a third variation of the interconnector in this embodiment.
Fig. 32 is a plan view showing a series of photoelectric conversion elements connected to one another through interconnectors according to a fourth variation in this embodiment.
Fig. 33 is a partial enlarged plan view showing a portion of connection between the interconnector and the electrode shown in Fig. 32 in this embodiment.
Fig. 34 is a partial enlarged plan view showing a portion of connection between an interconnector according to a fifth variation and the electrode in this embodiment.
Fig. 35 is a cross-sectional view showing a structure in a variation of the cell substrate of the photoelectric conversion element in this embodiment.
Fig. 36 is a cross-sectional view showing one step in a method of manufacturing a photoelectric conversion element according to the variation in this embodiment.
Fig. 37 is a cross-sectional view showing a step performed subsequent to the step shown in Fig. 36 in this embodiment.
Fig. 38 is a cross-sectional view showing a step performed subsequent to the step shown in Fig. 37 in this embodiment.
Fig. 39 is a cross-sectional view showing a step performed subsequent to the step shown in Fig. 38 in this embodiment.
Fig. 40 is a cross-sectional view showing a step performed subsequent to the step shown in Fig. 39 in this embodiment.
Fig. 41 is a cross-sectional view showing a step performed subsequent to the step shown in Fig. 40 in this embodiment.
Fig. 42 is a cross-sectional view showing a step performed subsequent to the step shown in Fig. 41 in this embodiment.
Fig. 43 is a cross-sectional view showing a step performed subsequent to the step shown in Fig. 42 in this embodiment.
Fig. 44 is a cross-sectional view showing a step performed subsequent to the step shown in Fig. 43 in this embodiment.
Fig. 45 is a cross-sectional view showing a structure of a photoelectric conversion module according to a second embodiment of the present invention.
Fig. 46 is a plan view showing a structure of a conventional interconnector and a photoelectric conversion element including the interconnector.

### DESCRIPTION OF THE REFERENCE SIGNS

1 photoelectric conversion element; 2 semiconductor substrate; 3 p-type semiconductor layer; 4 n-type semiconductor layer; 5 through hole; 6 anti-reflection coating; 7 light-receiving-surface electrode; 8 n electrode; 9 p electrode; 10 insulating layer; 11 cell substrate; 12 a series of photoelectric conversion elements; 15 diffusion prevention film; 20 interconnector; 21 extending portion; 22 connection portion; 23 extending portion; 30 photoelectric conversion module; 31 back film; 32 sealing material; 33 glass plate; 34 frame; 35a, 35b external terminal; 41 semiconductor substrate; 42 n-type layer; 43 p-type layer; 44 n electrode; 45 p electrode; 46 anti-reflection coating; 48 texture mask; 49 first diffusion mask; 50 second diffusion mask; 51 passivation film; 5 1a, 51b contact hole; and 60 conductor line.

### BEST MODES FOR CARRYING OUT THE INVENTION

### First Embodiment

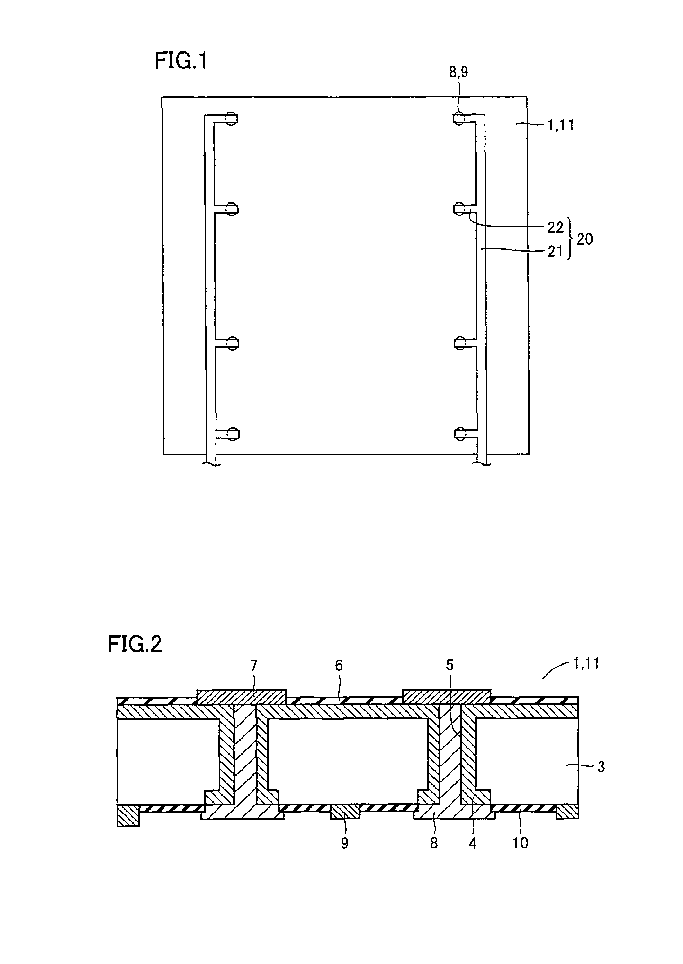

Initially, a basic structure of an interconnector (an element interconnection member) according to an embodiment of the present invention will be described. As shown in Fig. 1, an interconnector 20 includes an extending portion 21 extending in one direction and a connection portion 22 fixed to an n electrode 8 or a p electrode 9 formed on a cell substrate (a photoelectric conversion substrate) 11 of a photoelectric conversion element 1 for connection to these electrodes 8, 9. This one direction is based on a direction in which cell substrates 11 are arranged or a direction in which electrodes 8 and 9 are arranged. Connection portion 22 is formed in a comb shape so as to protrude from extending portion 21 in a direction substantially orthogonal to that one direction. Though extending portion 21 comes in contact with cell substrate 11, it is not fixed to cell substrate 11.

As will be described later, by not fixing extending portion 21 of interconnector 20 to cell substrate 11, stress involved with heat shrinkage can be released. In addition, connection portion 22 of interconnector 20 is formed in a comb shape relative to extending portion 21 so that a degree of freedom in arrangement of n electrodes 8 and p electrodes 9 formed on photoelectric conversion element 1 can be enhanced.

A series of photoelectric conversion elements (a photoelectric conversion element string) obtained by electrically connecting a plurality of photoelectric conversion elements to one another through such interconnectors will now specifically be described in detail. Initially, a photoelectric conversion element will be described. As shown in Figs. 2, 3 and 4, photoelectric conversion element 1 is formed of cell substrate 11, for example, having a side of approximately 155 mm and a thickness of approximately 200 µm. In cell substrate 11, a through hole 5 passing through a p-type semiconductor layer 3 is formed, and an n-type semiconductor layer 4 is formed on a surface of p-type semiconductor layer 3 including a sidewall of through hole 5.

N electrode 8 in contact with that n-type semiconductor layer 4 and filling through hole 5 is formed to be exposed on a back surface side. In addition, p electrode 9 is formed on a surface on the back surface side of p-type semiconductor layer 3. An insulating layer 10 is formed on the surface on the back surface side of p-type semiconductor layer 3. On the back surface of photoelectric conversion element 1, electrodes of the same polarity (n electrodes 8a to 8e and p electrodes 9a to 9d) are arranged in a row direction, and n electrodes 8a to 8e and p electrodes 9a to 9d are alternately arranged in a column direction. On the other hand, a light-receiving-surface electrode 7 and an anti-reflection coating 6 are formed on a light-receiving surface of n-type semiconductor layer 4.

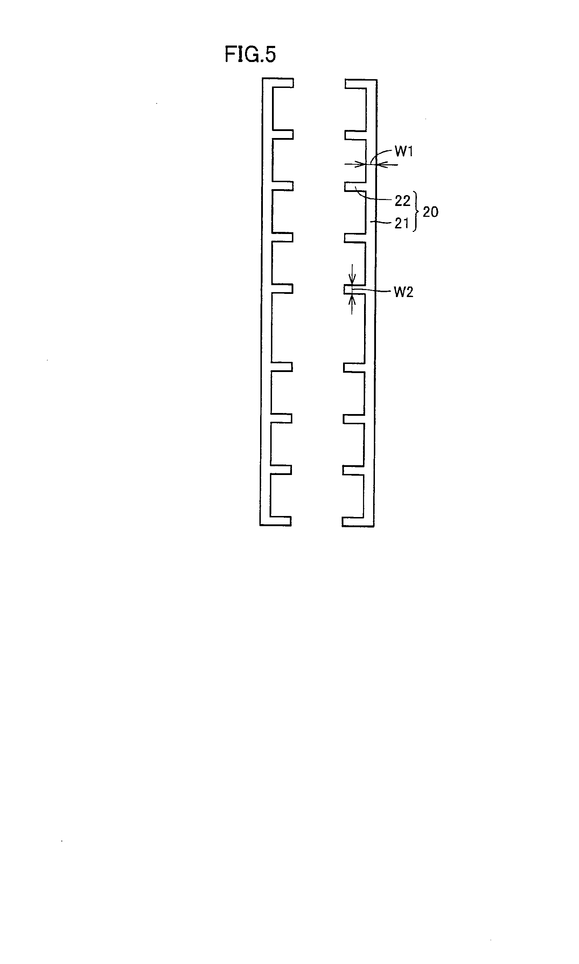

An interconnector will now be described. As shown in Fig. 5, interconnector 20 is constituted of extending portion 21 and connection portion 22. Extending portion 21 extends in one direction and connection portion 22 is formed to protrude in a comb shape relative to extending portion 21, in correspondence with arrangement of n electrodes or p electrodes. Interconnector 20 is formed, for example, of a solder-plated conductive member (copper). A width W1 of extending portion 21 is set, for example, to 5 mm, and a width W2 of connection portion 22 is set, for example, to 3 mm. In addition, a thickness is set, for example, to 0.1 mm. It is noted that, for example, an alloy of copper/aluminum/copper, an alloy of copper/Invar/copper, or the like in addition to copper may be employed as the conductive member.

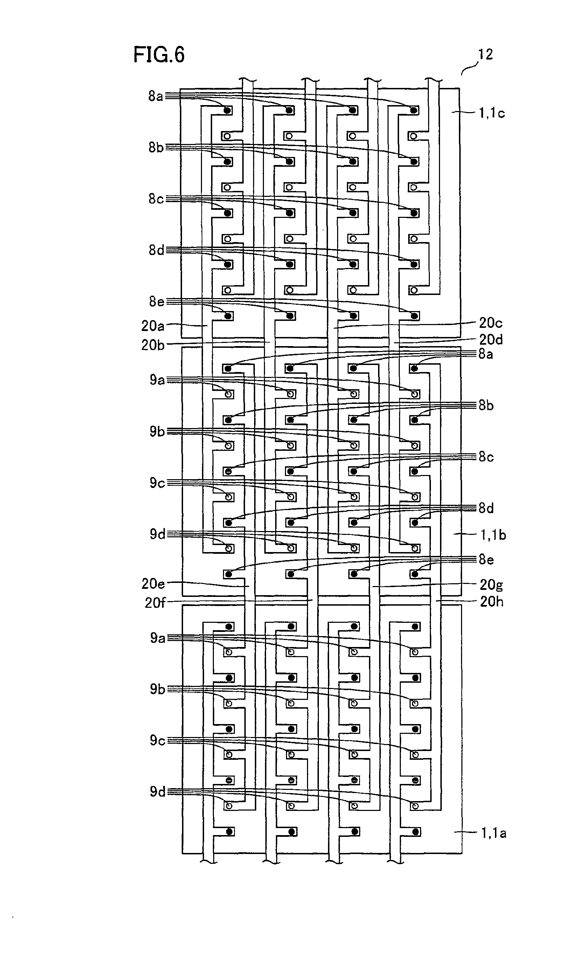

A series of photoelectric conversion elements will now be described. As shown in Fig. 6, in each of cell substrates 11a, 11b and 11c of photoelectric conversion elements 1 constituting a series of photoelectric conversion elements 12, electrodes of the same polarity (n electrodes 8a to 8e and p electrodes 9a to 9d) are arranged in a row direction, and n electrodes 8a to 8e and p electrodes 9a to 9d are alternately arranged in a column direction. A first interconnector 20a electrically connects p electrodes 9a to 9d in the first column of an nth photoelectric conversion element 1b and n electrodes 8a to 8e in the first column of an n+1th photoelectric conversion element 1c. In addition, a second interconnector 20b electrically connects p electrodes 9a to 9d in the second column of nth photoelectric conversion element 1b and n electrodes 8a to 8e in the second column of n+1th photoelectric conversion element 1c.

Similarly hereafter, a third interconnector 20c electrically connects p electrodes 9a to 9d in the third column of photoelectric conversion element 1b and n electrodes 8a to 8e in the third column of photoelectric conversion element 1c, and a fourth interconnector 20d electrically connects p electrodes 9a to 9d in the fourth column of photoelectric conversion element 1b and n electrodes 8a to 8e in the fourth column of photoelectric conversion element 1c. Thus, an nth interconnector group constituted of four interconnectors 20a to 20d electrically connects p electrodes 9a to 9d of nth photoelectric conversion element 1b and n electrodes 8a to 8e of n+1th photoelectric conversion element 1c.

Similarly, an n-1th interconnector group constituted of four interconnectors 20e to 20h electrically connects, for each column, p electrodes 9a to 9d in four columns of an n-1th photoelectric conversion element 1a and n electrodes 8a to 8e in four columns of nth photoelectric conversion element 1b. Similarly, interconnectors electrically connect also n electrodes and p electrodes in other photoelectric conversion elements.

An exemplary method of manufacturing a series of photoelectric conversion elements described above will now be described.

### (1) Step of forming a through hole and surface irregularities

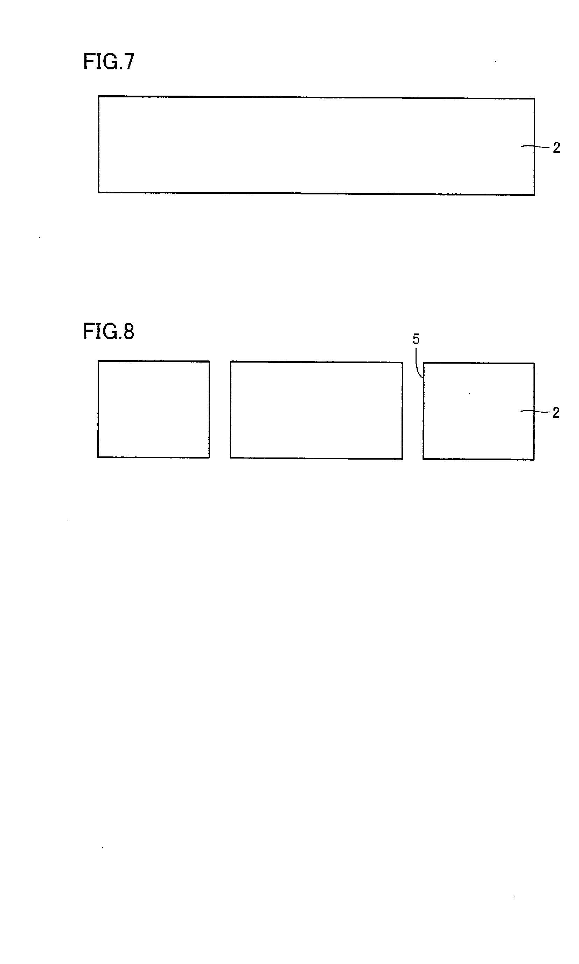

Initially, as shown in Fig. 7, a p-type semiconductor substrate 2 is prepared. Though a crystalline silicon substrate is applied as semiconductor substrate 2 by way of example, the substrate is not limited thereto. Semiconductor substrate 2 has a thickness preferably from approximately 10 to 300 µm and further preferably from approximately 50 to 100 µm. Then, as shown in Fig. 8, p-type semiconductor substrate 2 is subjected to laser processing, so as to form, for example, annular through hole 5 having a diameter of approximately 0.3 mm.

A shape or a dimension of through hole 5 is not limited as such, and a desired shape or dimension adapted to specifications or the like of a series of photoelectric conversion elements is adopted. In addition, how to form through hole 5 is not limited to laser processing. Then, semiconductor substrate 2 is etched with an acid or alkaline solution or etched with reactive plasma, to thereby form an irregular structure (a textured structure) on a surface of semiconductor substrate 2 (not shown).

### (2) Step of forming an n-type layer

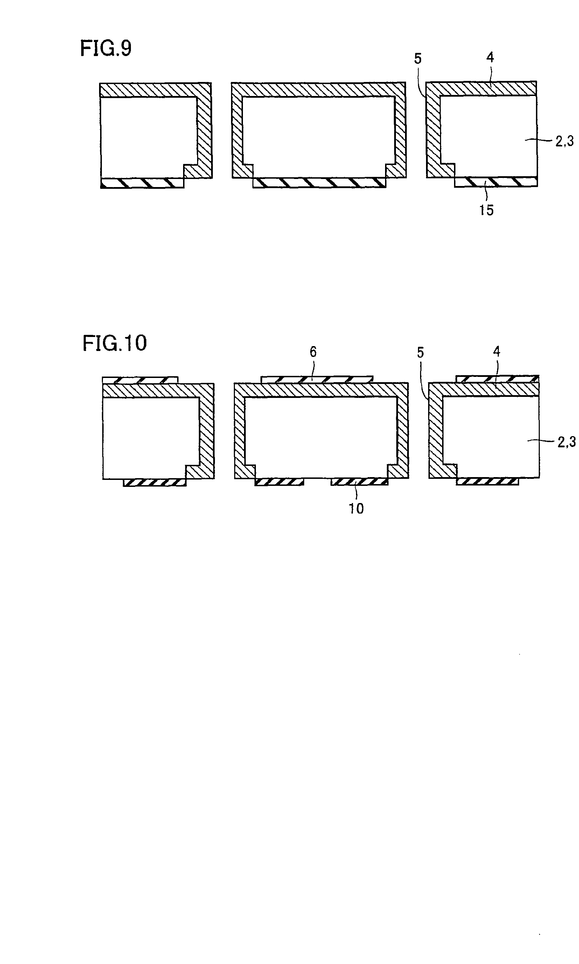

Then, as shown in Fig. 9, a diffusion prevention mask 15 formed, for example, of a silicon oxide film is formed in a region of the back surface of semiconductor substrate 2 other than a periphery of through hole 5 with an atmospheric pressure CVD (Chemical Vapor Deposition) method. Then, semiconductor substrate 2 is exposed to a gas at a high temperature containing a material containing such an n-type impurity as POCl₃, so that the n-type impurity is introduced in a region not covered with diffusion prevention mask 15 and thus n-type semiconductor layer 4 is formed.

Namely, n-type semiconductor layer 4 is formed to a prescribed depth from a surface of each of the region on the surface (light-receiving surface) side of semiconductor substrate 2, an inner wall of through hole 5, and the region not covered with diffusion prevention mask 15 on the back surface side of semiconductor substrate 2. Then, diffusion prevention mask 15 is removed with prescribed etching, to thereby expose the region of p-type semiconductor substrate 2 as p-type semiconductor layer 3.

A method of forming an n-type semiconductor layer is not limited to the method described above, and for example, n-type semiconductor layer 4 may be formed, for example, by implanting n-type impurity ions in semiconductor substrate 2 with an ion implantation method. Alternatively, an n-type semiconductor layer may separately be formed on the surface of semiconductor substrate 2, for example, with a CVD method. In this case, p-type semiconductor substrate 2 itself serves as p-type semiconductor layer 3.

### (3) Step of forming an anti-reflection coating and an insulating layer

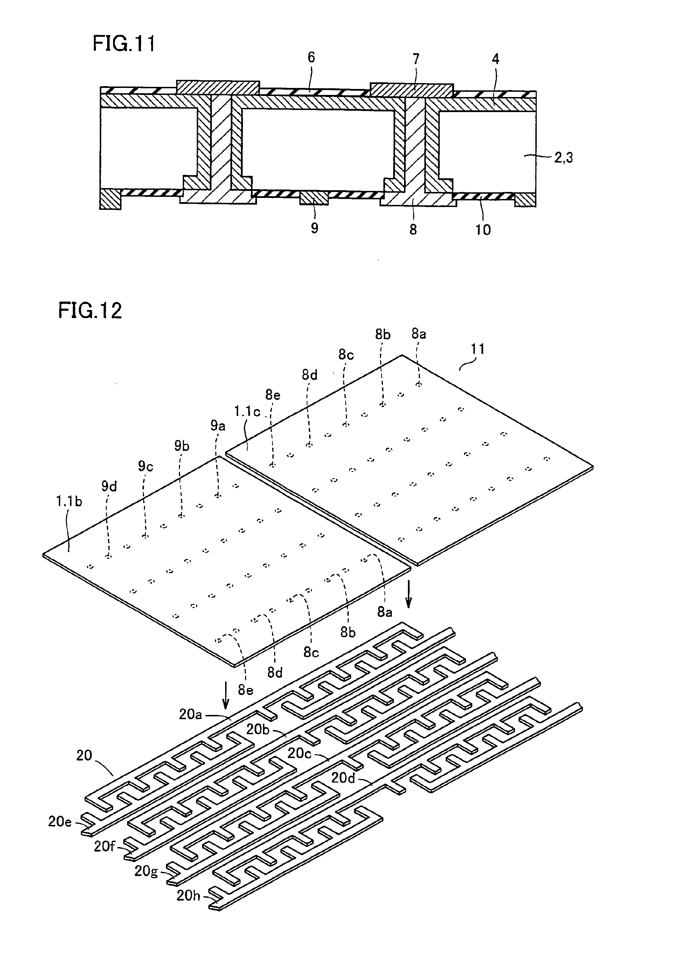

Then, as shown in Fig. 10, an anti-reflection coating 6 formed of a silicon nitride film having a thickness of approximately 70 nm is formed, for example, with a plasma CVD method, on the surface of n-type semiconductor layer 4 located on the light-receiving surface side, except for through hole 5 and a region around the through hole where the light-receiving-surface electrode is to be formed. It is noted that the anti-reflection coating may be formed to cover the entire surface of n-type semiconductor layer 4 located on the light-receiving surface side. In this case, a light-receiving-surface electrode 7 (see Fig. 11) is formed on a surface of anti-reflection coating 6, which leads to conduction between the light-receiving-surface electrode and the n-type semiconductor layer owing to fire-through. So long as an anti-reflection coating has a function to suppress reflection at the surface, a material, a thickness, a method of forming, and the like of anti-reflection coating 6 is not particularly limited.

Meanwhile, insulating layer 10 composed of silicon oxide and having a thickness from approximately 50 to 100 nm is formed with a CVD method or a sputtering method on the surface of p-type semiconductor layer 3 exposed on the back surface side, except for a region where p electrode 9 (see Fig. 11) is to be formed. The insulating layer may be formed to cover the entire surface of p-type semiconductor layer 3 located on the back surface side. In this case, the p electrode is formed on a surface of insulating layer 10, which leads to conduction between the p electrode and p-type semiconductor layer 3 owing to fire-through.

So long as an insulating layer is capable of electrically isolating p-type semiconductor layer 3 and the n electrode from each other, a material, a thickness, a method of forming, and the like of insulating layer 10 is not particularly limited. An insulating layer composed, for example, of silicon nitride, tantalum oxide, aluminum oxide, or the like, other than silicon oxide, may be formed. In particular, tantalum oxide can be formed, for example, with a method described in a document (Fujikawa et al., Preparation of High Dielectric Ta2O5-based Composite Films, R&D Review of Toyota CRDL, Vol. 30, No. 4, pp. 12-23, 1995. 12).

### (4) Step of forming a light-receiving-surface electrode, an n electrode and a p electrode

Then, as shown in Fig. 11, for example by printing such a paste material as silver onto through hole 5 and the region where p electrode 9 is to be formed on the back surface of semiconductor substrate 2 and firing the paste material, through hole 5 is filled therewith and a plurality of n electrodes 8 exposed at the back surface of semiconductor substrate 2 are formed and a plurality of p electrodes 9 are formed on the back surface side of p-type semiconductor layer 3. In addition, by printing such a paste material as silver onto the light-receiving surface and firing the paste material, light-receiving-surface electrode 7 is formed on the light-receiving surface of n-type semiconductor layer 4.

It is noted that, in addition to silver, for example, a metal material such as aluminum, copper, nickel, and palladium may be used to form light-receiving-surface electrode 7, n electrode 8 and p electrode 9. Moreover, these electrodes may be formed with a vapor deposition method in addition to printing of a paste material. Further, after light-receiving-surface electrode 7, n electrode 8 and p electrode 9 are formed, heat treatment or forming gas annealing may be performed as necessary. One photoelectric conversion element (cell substrate) is thus formed. A plurality of photoelectric conversion elements are similarly formed.

### (5) Step of connecting the interconnector

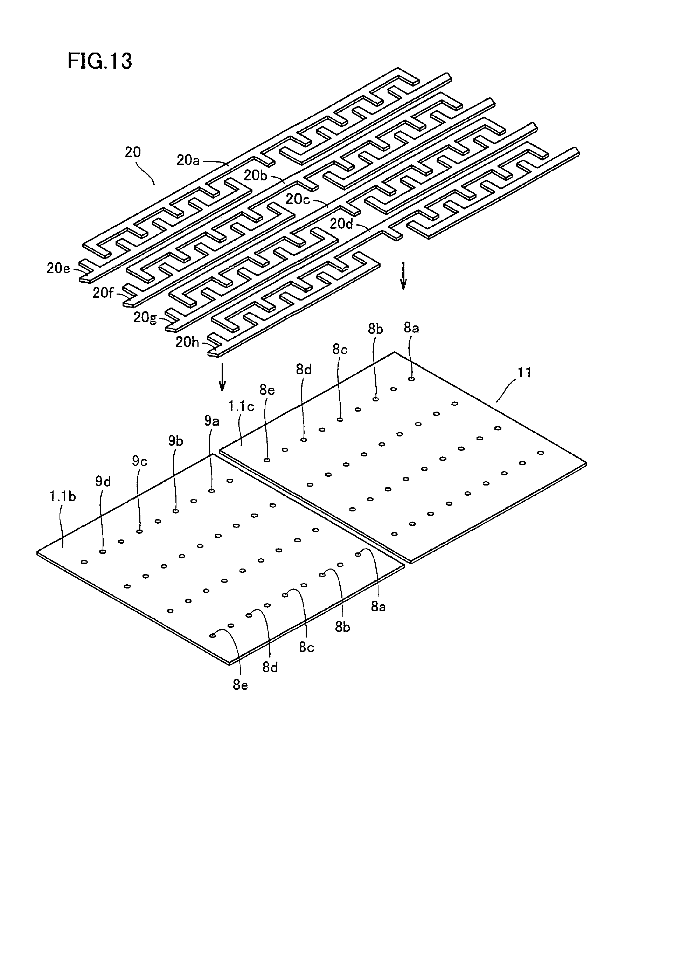

Then, the plurality of photoelectric conversion elements (cell substrates) are electrically connected to one another through the interconnectors. Here, a technique (technique A) for placing cell substrate 11 of photoelectric conversion element 1 on interconnector 20 for connection as shown in Fig. 12 and a technique (technique B) for placing interconnector 20 on cell substrate 11 for connection as shown in Fig. 13 are available.

According to technique A, initially, interconnectors 20 for one cell substrate 11 are arranged at prescribed positions in a prescribed jig (not shown). Here, interconnectors 20 may be held with vacuum pick-up. Then, cell substrates 11 are arranged at prescribed positions (coordinates) set in advance relative to interconnectors 20. In addition, at this time, relative positional relation between interconnectors 20 and cell substrates 11 may finely be adjusted based on image recognition. Then, a prescribed load is applied from above cell substrates 11, and cell substrates 11 and interconnectors 20 are subjected to heat treatment at a prescribed temperature in a reflow furnace. Thereafter, cell substrates 11 and interconnectors 20 are cooled, to thereby connect interconnectors 20 to cell substrates 11.

Meanwhile, according to technique B, an image of a mark (not shown) for positioning, that has been formed in advance in cell substrate 11, is recognized, so that cell substrate 11 is arranged at a prescribed position. Alternatively, in a case of cell substrate 11 where n electrodes or p electrodes thereon are formed with a prescribed corner of cell substrate 11 serving as the reference, that corner may be set at a prescribed position.

Then, interconnectors 20 are placed at prescribed positions with respect to cell substrates 11. Here, relative positional relation between interconnectors 20 and cell substrates 11 may finely be adjusted based on image recognition. It is noted that placement of interconnectors 20 on cell substrates 11 includes a method of placing interconnector 20 one by one at a prescribed position of the cell substrate and a method of arranging interconnectors 20 (an interconnector group) for one cell substrate 1 in a different location and thereafter collectively placing the interconnector group on cell substrates 11.

Then, a prescribed load is applied from above interconnectors 20, and cell substrates 11 and interconnectors 20 are subjected to heat treatment at a prescribed temperature in a reflow furnace. Thereafter, cell substrates 11 and interconnectors 20 are cooled, to thereby connect interconnectors 20 to cell substrates 11. A series of photoelectric conversion elements 12 (string) obtained by connecting interconnectors 20 to cell substrates 11 is thus formed.

In the series of photoelectric conversion elements 12 described above, extending portion 21 of interconnector 20 for connecting a plurality of cell substrates (photoelectric conversion elements) 11 to one another is not fixed to cell substrate 11, so that stress involved with heat shrinkage can be released, which will now be described.

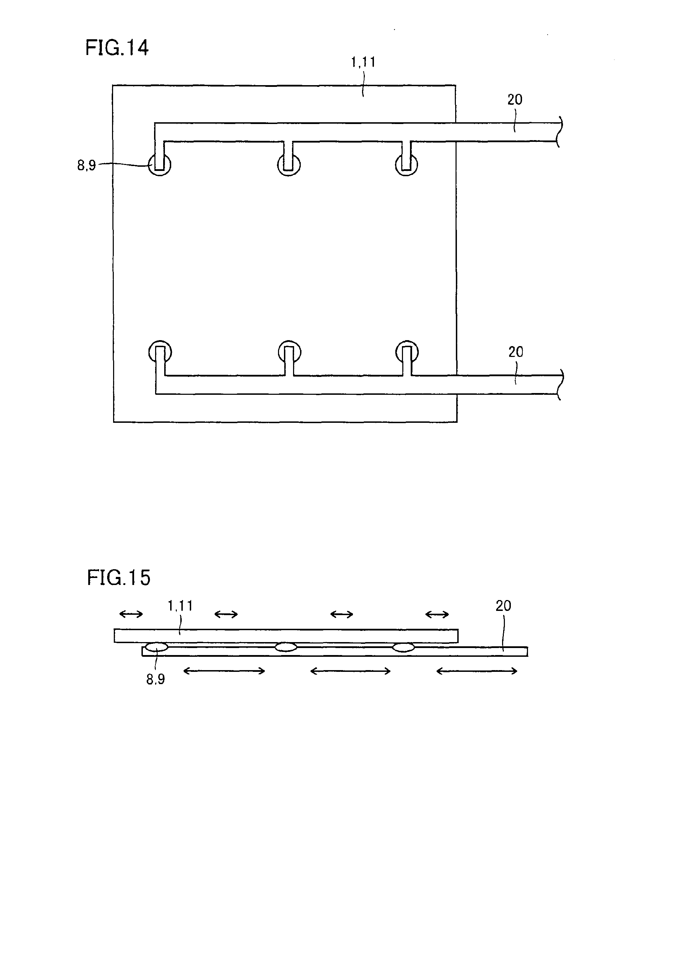

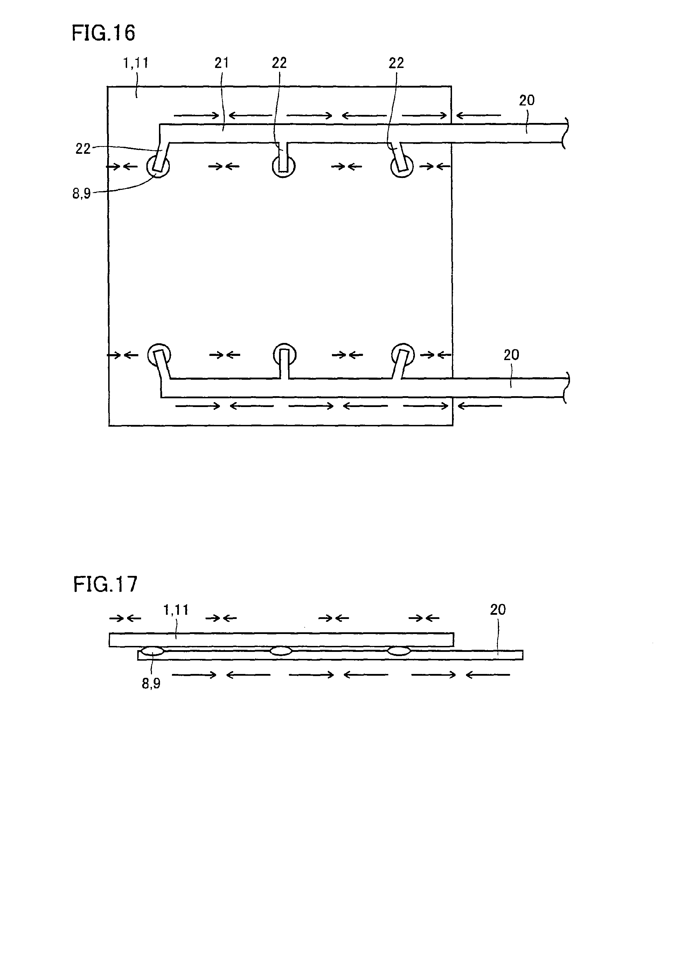

Interconnector 20 is subjected to heat treatment while interconnector 20 is in contact with cell substrate 11 in the reflow furnace followed by cooling, so that interconnector 20 is fixed and connected to cell substrate 11. Interconnector 20 is greater in coefficient of thermal expansion than cell substrate 11. Therefore, initially, in the reflow furnace, interconnector 20 is in contact with cell substrate 11 while interconnector 20 thermally expands more than cell substrate 11 as shown in Figs. 14 and 15 (see arrows). Then, by cooling interconnector 20 and cell substrate 11, connection portion 21 is fixed to cell substrate 11 while interconnector 20 contracts more than cell substrate 11 as shown in Figs. 16 and 17 (see arrows). Meanwhile, here, extending portion 21 of interconnector 20 is not fixed to cell substrate 11.

Thus, connection portion 22 protruding in a direction orthogonal to a direction of heat shrinkage of extending portion 21 of interconnector 20 deforms and stress involved with heat shrinkage of interconnector 20 is absorbed by connection portion 22. Consequently, stress involved with heat shrinkage of interconnector 20 is prevented from affecting cell substrate 11 so that warping of cell substrate 11 can be prevented. In addition, loss of good electrical connection between interconnector 20 and cell substrate 11 due to warping of the cell substrate can be suppressed. It is noted that deformation of connection portion 22 is shown as exaggerated in Fig. 16, in order to show a manner of absorption of stress by connection portion 22 of interconnector 20.

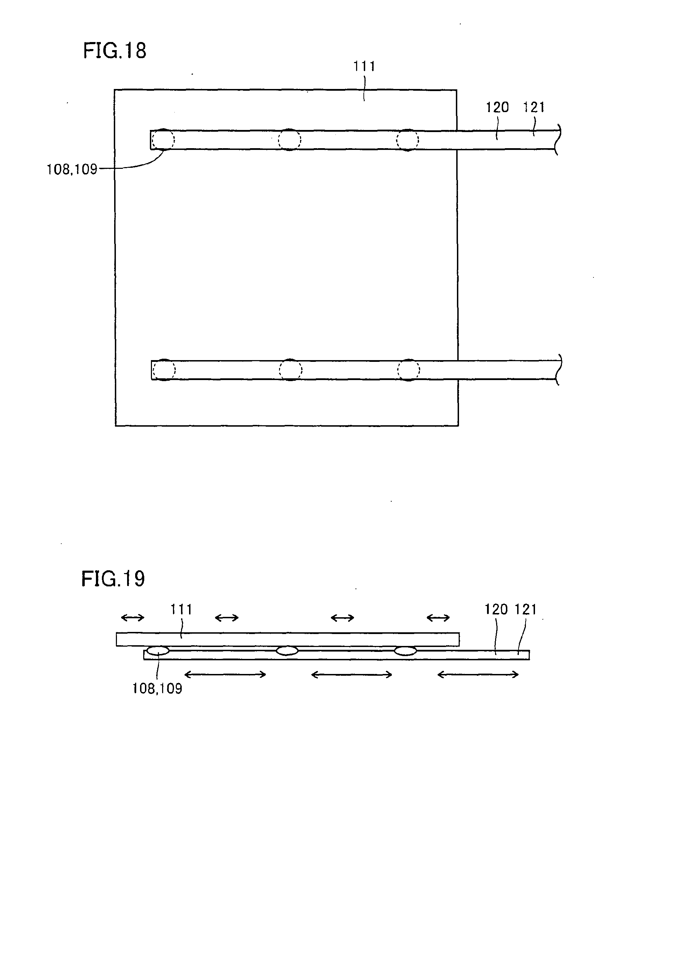

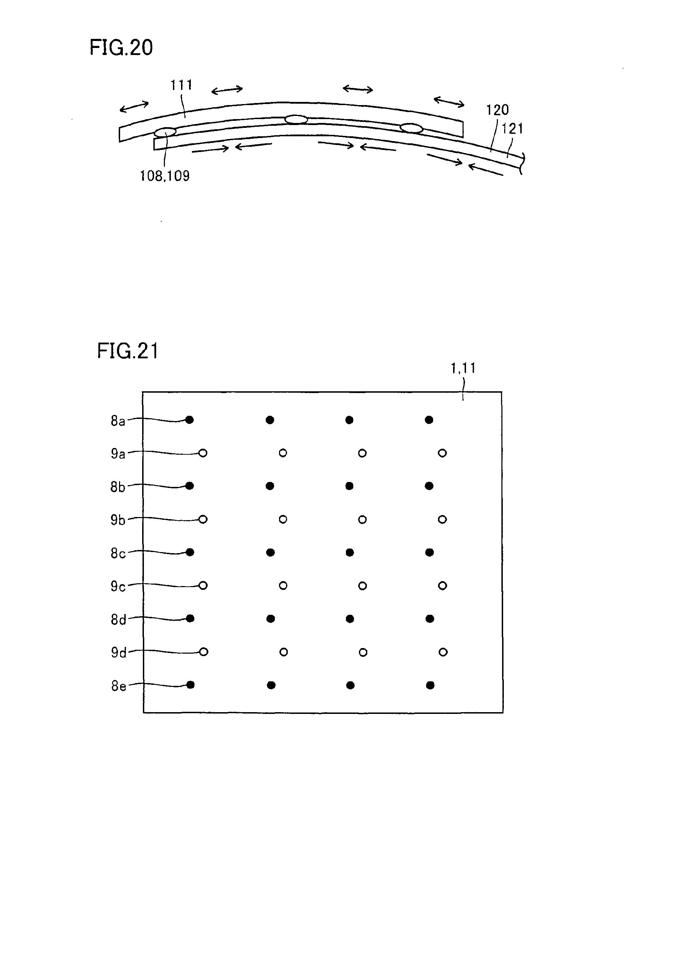

In contrast, a case where a conventional interconnector is connected to a cell substrate will be described by way of a comparative example. The conventional interconnector is also subjected to heat treatment while the interconnector is in contact with the cell substrate in the reflow furnace followed by cooling, so that the interconnector is connected to the cell substrate. In the reflow furnace, interconnector 120 is in contact with cell substrate 111 while interconnector 120 thermally expands more than cell substrate 111 as shown in Figs. 18 and 19 (see arrows). Then, by cooling interconnector 120 and cell substrate 111, extending portion 121 is fixed to cell substrate 111 while interconnector 120 contracts more than cell substrate 111 as shown in Fig. 20 (see arrows).

Here, conventional interconnector 120 consists only of extending portion 121 and a prescribed portion of that extending portion 121 is fixed to an n electrode or a p electrode. Therefore, stress of extending portion 121 experiencing heat shrinkage is applied to a portion of the n electrode or the p electrode to which extending portion 121 is fixed, which results in warping of cell substrate 111.

Thus, in the case of conventional interconnector 120, as extending portion 121 of interconnector 120 experiencing heat shrinkage is fixed to an n electrode or a p electrode, stress involved with heat shrinkage of extending portion 121 is applied to cell substrate 111 where the n electrode or the p electrode is formed and hence cell substrate 111 warps. In contrast, in the case of interconnector 20 described above, extending portion 21 experiencing heat shrinkage is not fixed to cell substrate 11 but connection portion 21 is fixed thereto. Therefore, stress involved with heat shrinkage of extending portion 21 is absorbed by connection portion 22 and thus cell substrate 11 can be prevented from warping.

In the step of connecting the interconnector described above, a connection method using heat treatment in a reflow furnace has been described by way of example of a method of connecting interconnector 20. The connection method, however, is not limited as such, and an interconnector may be connected to a cell substrate by locally heating solder, for example, by blowing hot air onto solder or irradiating solder with laser beams. Alternatively, an anisotropic conductive film (ACF), an anisotropic conductive paste (ACP), or a conductive adhesive may be used instead of solder for connecting the interconnector to the cell substrate.

### (Variation of Arrangement Pattern of n Electrodes and p Electrodes on Cell Substrate)

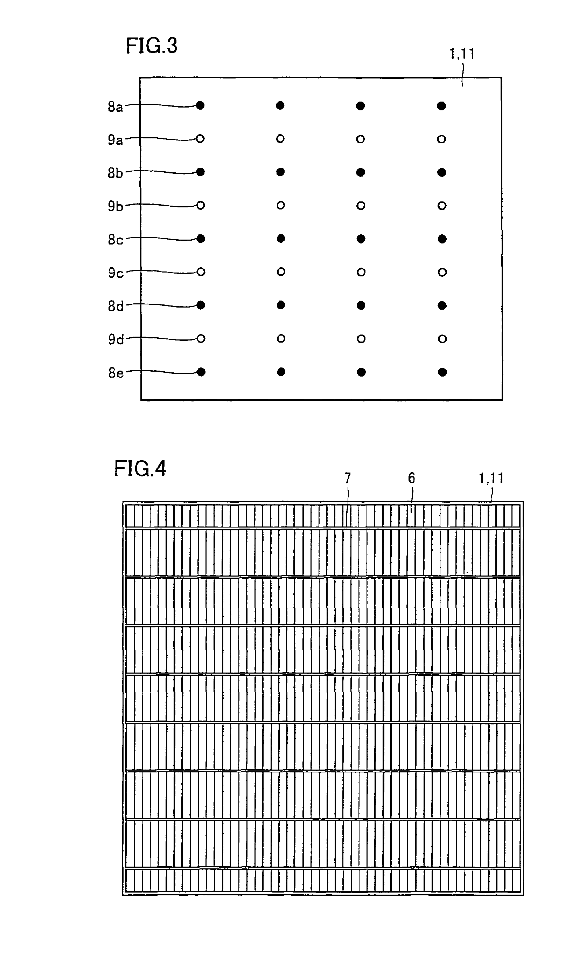

A pattern in which n electrodes 8a to 8d and p electrodes 9a to 9d are alternately arranged linearly in a column direction has been described by way of example of an arrangement pattern of n electrodes and p electrodes formed on the back surface of the cell substrate of the photoelectric conversion element described above (see Fig. 3).
The arrangement pattern of the n electrodes and the p electrodes is not limited to the arrangement pattern described above, so long as an arrangement pattern is such that a current is efficiently extracted from the cell substrate, connection strength between the cell substrate and the interconnector is ensured, the number of interconnectors is decreased, and the step of connecting the interconnector to the cell substrate is simplified.

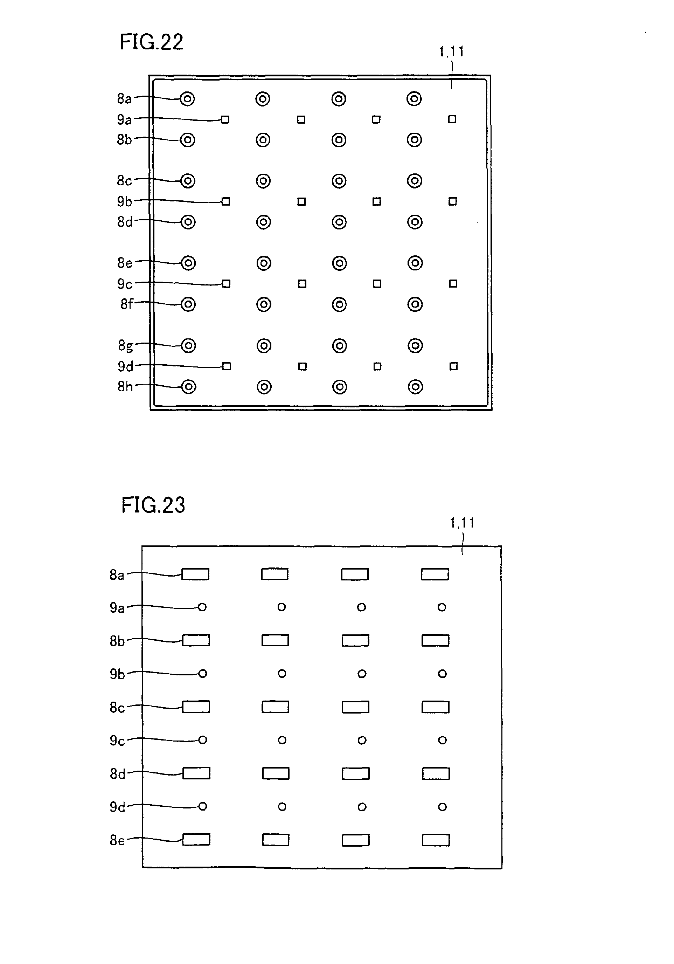

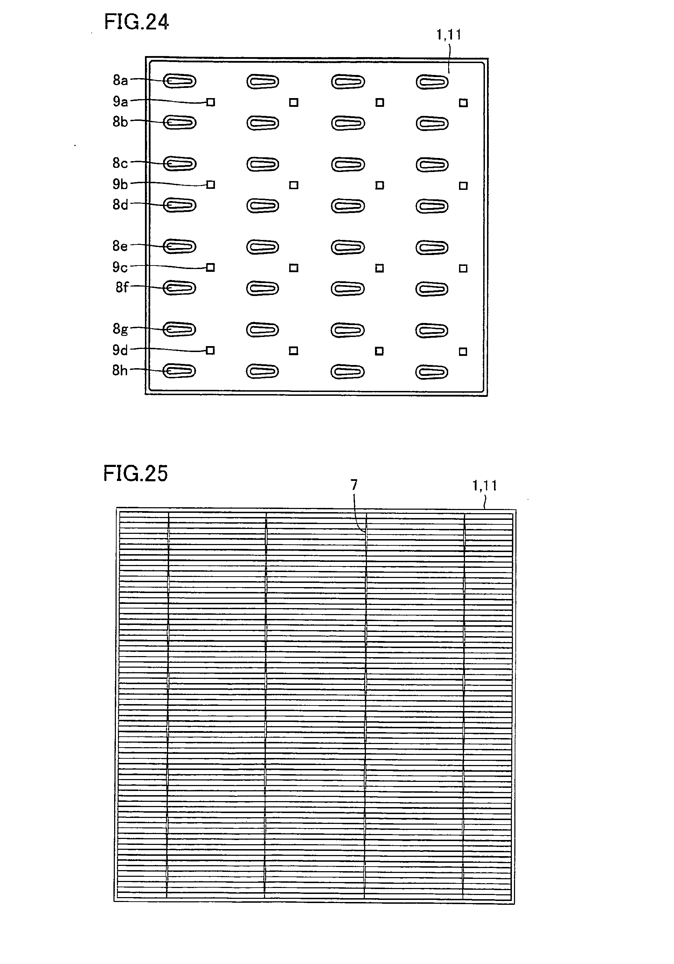

For example, as shown in Fig. 21, such a pattern that a position of a column of n electrodes 8a to 8d is slightly displaced from a position of a column of p electrodes 9a to 9d may be adopted. Alternatively, as shown in Fig. 22, a pattern may be such that an interval between n electrodes is different from an interval between p electrodes.
Further alternatively, such a pattern as shown in Fig. 23 that n electrodes 8a to 8d and p electrodes 9a to 9d different in shape are alternately linearly arranged or such a pattern as shown in Fig. 24 that n electrodes 8a to 8h and p electrodes 9a to 9d in such a shape are arranged with an interval between the n electrodes being different from an interval between the p electrodes may be adopted. According to such an arrangement pattern as well, interconnector 20 can reliably be fixed to the n (p) electrode by adjusting a length of connection 22 portion of interconnector 20 or a position of connection portion 22 in extending portion 21.

Though a pattern shown in Fig. 4 has been described by way of example of light-receiving-surface electrodes on the light-receiving-surface side of the cell substrate, a pattern shown in Fig. 25 may be adopted as a pattern of light-receiving-surface electrodes 7, for example, in the case of the arrangement pattern of the n electrodes and the p electrodes shown in Fig. 24.

### (Method of Manufacturing Interconnector)

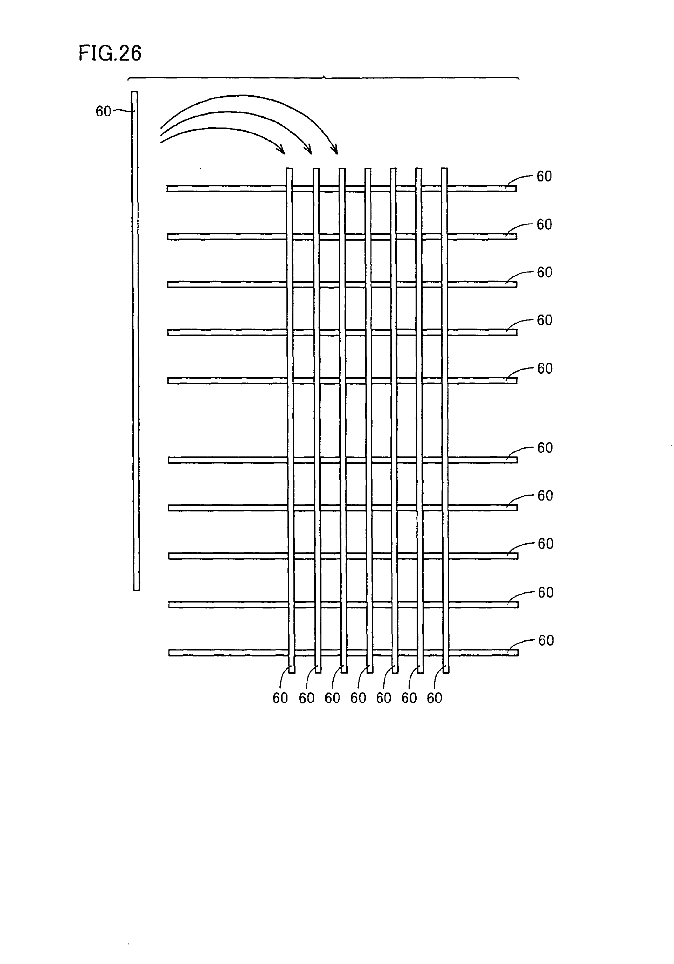

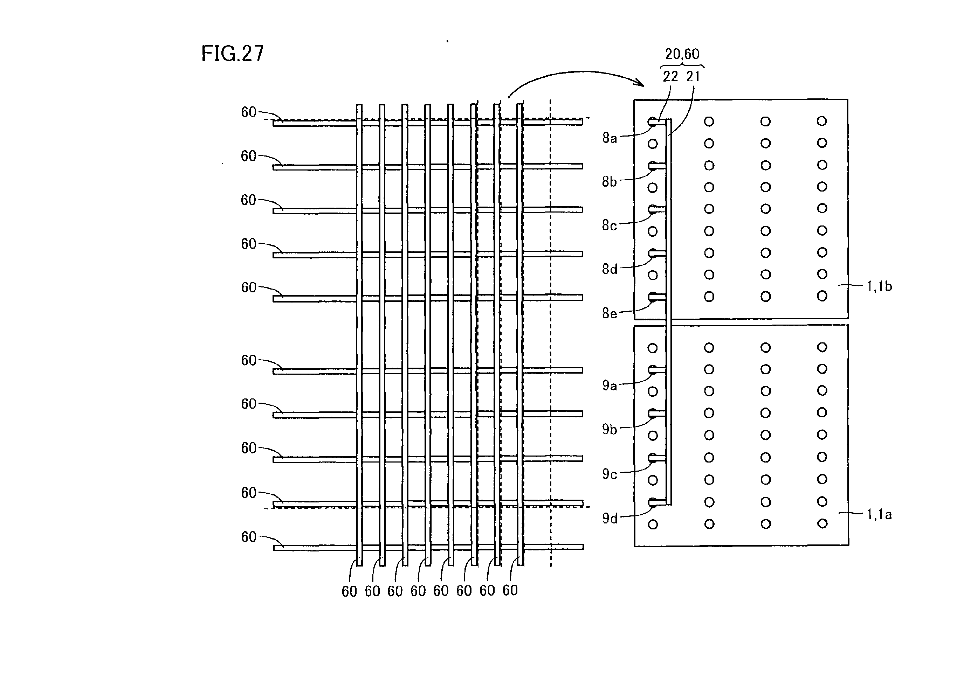

An exemplary method of manufacturing a comb-shaped interconnector will now be described. Initially, as shown in Fig. 26, bar-shaped conductors 60 extending with a prescribed width are connected to form a lattice shape, for example, by using solder. Then, as shown in Fig. 27, conductors 60 are cut along dotted lines, to thereby obtain interconnectors 20 each including extending portion 21 and connection portions 22. The photoelectric conversion elements are connected to one another by connecting each connection portion 22 of interconnector 20 to each of n electrodes 8a to 8e on corresponding photoelectric conversion element 1b and to each of p electrodes 9a to 9d on photoelectric conversion element 1a.

### (Variation of Interconnector)

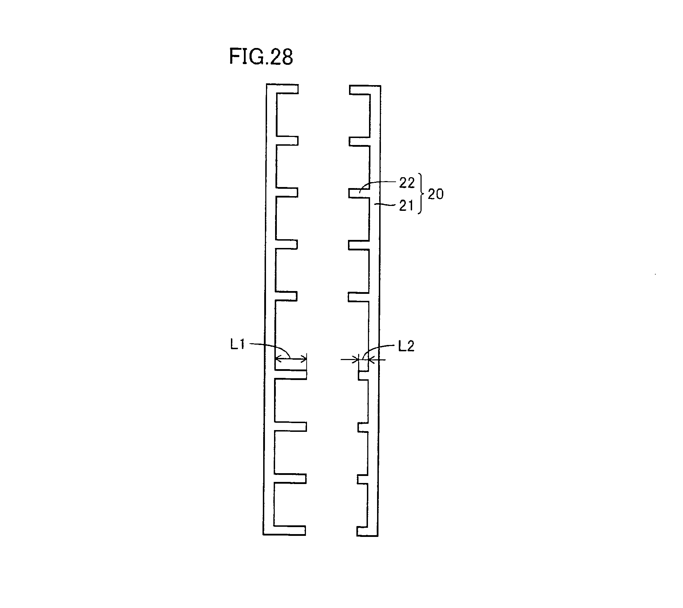

An exemplary variation of the interconnector will now be described. An interconnector is required to have a shape corresponding to an arrangement pattern of n electrodes and p electrodes formed on the back surface of the cell substrate. For example, interconnectors 20 different in lengths L1 and L2 of connection portion 22 protruding from extending portion 21 as shown in Fig. 28 are desirably applied as interconnectors to be applied to an arrangement pattern in which a column of the n electrodes and a column of the p electrodes are displaced from each other.

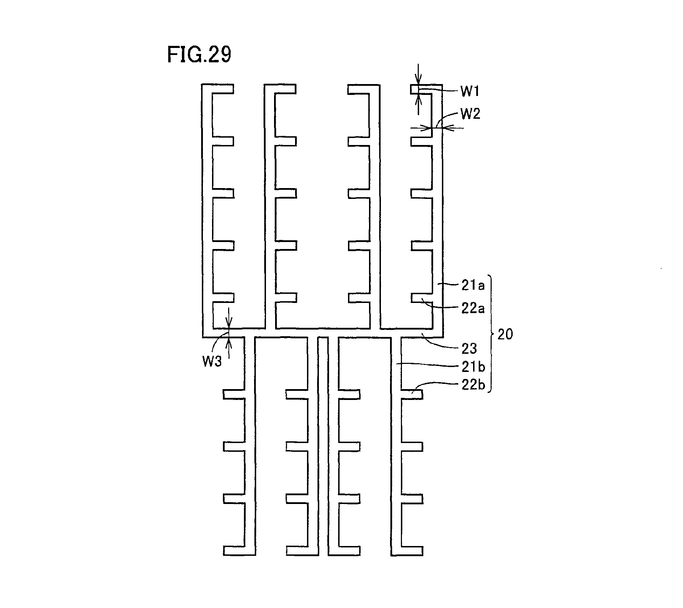

Alternatively, as shown in Fig. 29, such interconnector 20 that extending portions 21 of one interconnector 20 connecting n electrodes and p electrodes in each column are connected to each other through another extending portion 23 may be adopted. That interconnector 20 has a thickness t of approximately 0.1 mm, connection portion 22 has a width W1 of approximately 3 mm, extending portion 21 has a width W2 of approximately 5 mm, and extending portion 23 has a width W3 of approximately 10 mm. Preferably, thickness t is in a range from 0.01 mm to 0.5 mm, width W1 is in a range from 0.5 to 15 mm, width W2 is in a range from 1 to 20mm, and width W3 is in a range from 1 to 50 mm.

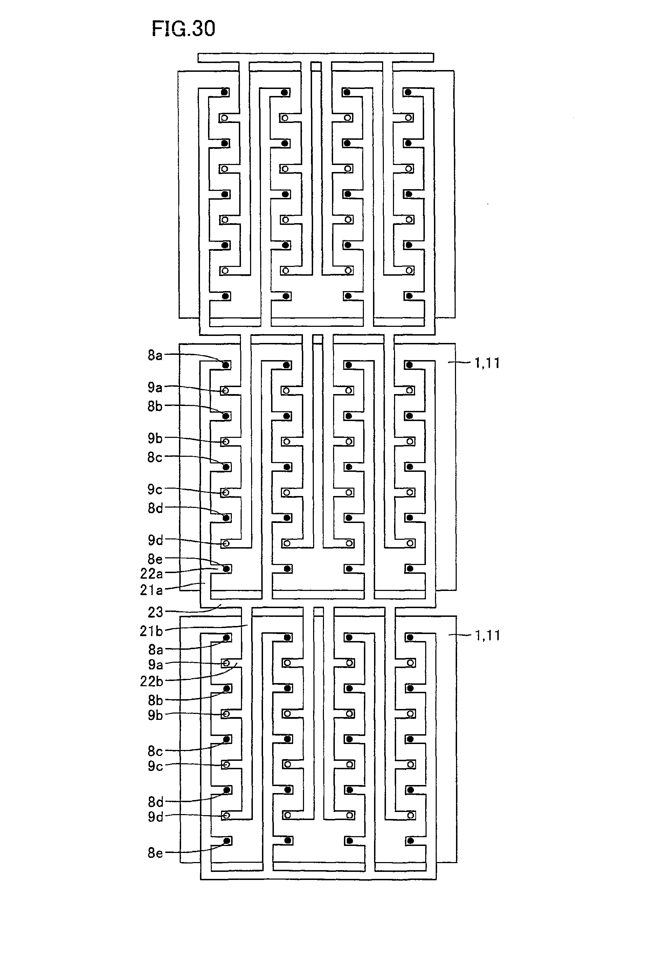

In addition, in the case of this interconnector 20, as shown in Fig. 30, a comb-shaped connection portion 22a provided in an extending portion 21a located on one side and a comb-shaped connection portion 22b provided in an extending portion 21b located on the other side, with extending portion 23 lying therebetween, are arranged such that connection portions 22a and 22b are connected to n electrodes 8a to 8e and p electrodes 9a to 9d arranged in a column direction from opposite directions, respectively, while interconnector 20 is connected to cell substrate 11.

Namely, in this interconnector 20, a pattern is set such that extending portion 21 a and connection portion 22a of one interconnector 20 connected to one cell substrate 11 do not two-dimensionally overlap with extending portion 21b and connection portion 22b of the other interconnector 20.

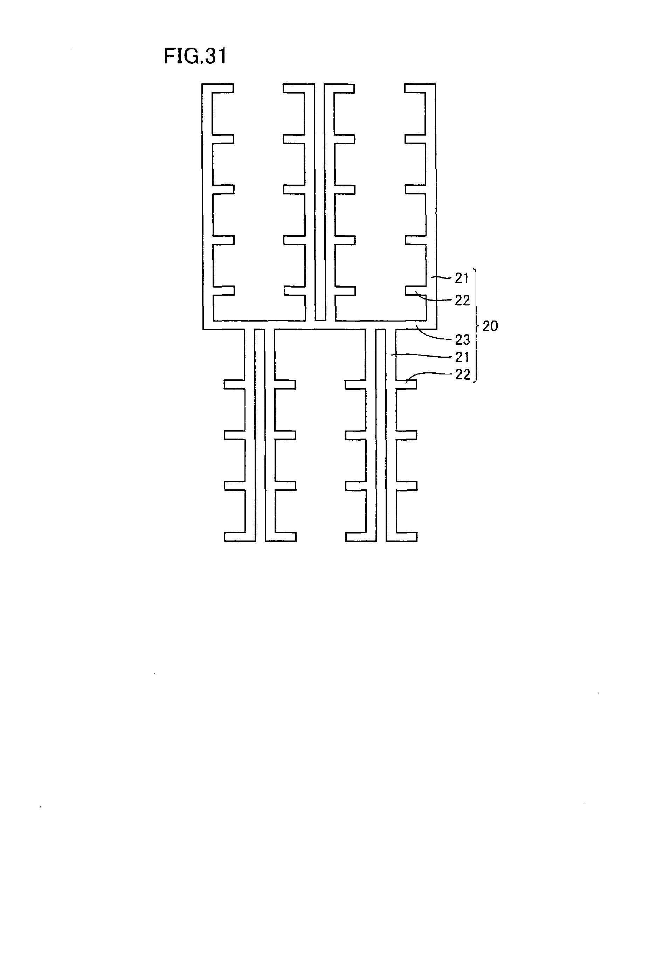

Thus, other than the interconnector shown in Fig. 29, an interconnector for example as shown in Fig. 31 may be adopted as such an interconnector that extending portion 21 and connection portion 22 of one interconnector 20 do not overlap with extending portion 21 and connection portion 2 of the other interconnector 20.

In particular, according to interconnector 20 of this type, adjacent cell substrates 11 can be connected to each other at once and efficiency in producing series of photoelectric conversion elements can be improved.

In addition, according to the present interconnector 20, a position where connection portion 22 is to be provided relative to extending portion 21 can be varied or a length of connection portion 22 can be varied, so that a degree of freedom of an arrangement pattern of n electrodes 8 and p electrodes 9 formed on cell substrate 11 can also be enhanced.

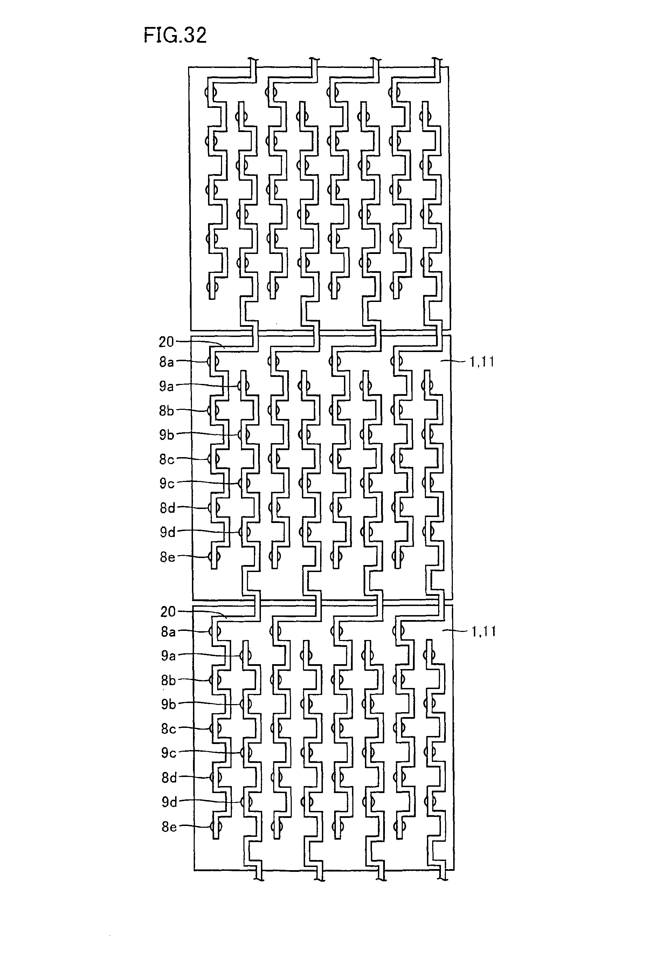

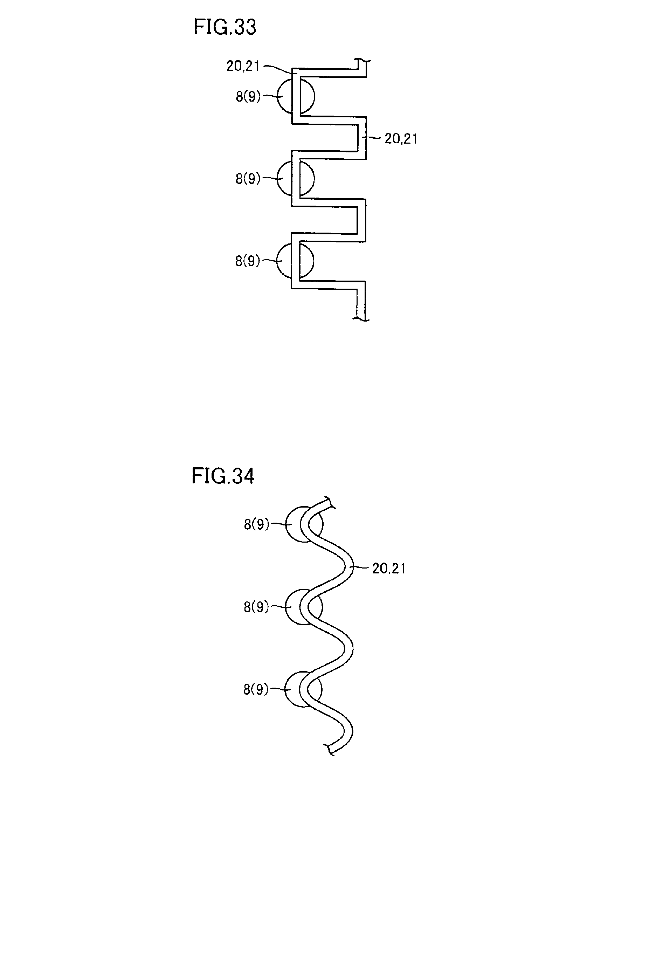

Another exemplary variation of the interconnector will now be described. As shown in Figs. 32 and 33, interconnector 20 includes zigzag-shaped extending portion 21. In particular, in this interconnector 20, extending portion 21 is in such a zigzag shape as bending a straight line. P electrodes 9a to 9d of photoelectric conversion element 1 and n electrodes 8a to 8e of another photoelectric conversion element 1 are electrically connected at prescribed portions of corresponding extending portion 21.

In interconnector 20 described above, extending portion 21 experiencing heat shrinkage is not fixed to cell substrate 11 at a portion other than portions where it is connected to p electrodes 9a to 9d or n electrodes 8a to 8e and extending portion 21 is in a zigzag shape. Thus, stress involved with heat shrinkage of extending portion 21 is absorbed by extending portion 21 itself and cell substrate 11 can be prevented from warping.

Though an interconnector of which extending portion is in such a zigzag shape as bending a straight line has been described above by way of example, a curved zigzag shape as shown in Fig. 34 may also be adopted. In this case as well, stress involved with heat shrinkage of extending portion 21 is absorbed by extending portion 21 itself and cell substrate 11 can be prevented from warping.

### (Variation of Photoelectric Conversion Element)

In a series of photoelectric conversion elements described above, such a photoelectric conversion element that a pn junction is provided on the light-receiving surface side and electrons generated at the light-receiving surface are extracted from an n electrode formed to fill a through hole has been described by way of example of the photoelectric conversion element (cell substrate). The photoelectric conversion element is not limited to such a photoelectric conversion element, and for example, a photoelectric conversion element including a pn junction on the back surface side may be adopted.

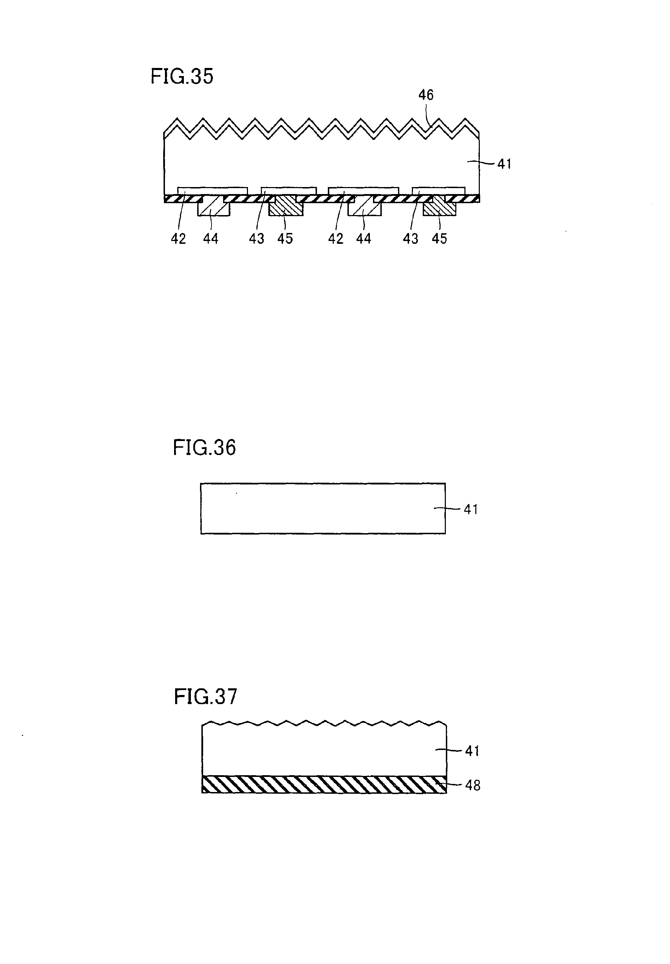

As shown in Fig. 35, in the photoelectric conversion element of this type, an n-type layer 42 and a p-type layer 43 are formed in prescribed regions respectively, on a back surface opposite to a light-receiving surface of an n-type semiconductor substrate 41. In addition, an n electrode 44 electrically connected to n-type layer 42 and a p electrode 45 electrically connected to p-type layer 43 are formed on the back surface. On the other hand, the light-receiving surface of semiconductor substrate 41 has a textured structure. An anti-reflection coating 46 is formed on the light-receiving surface. Since no electrode is provided on the light-receiving surface side in this photoelectric conversion element, this photoelectric conversion element can secure a light reception area greater than in a photoelectric conversion element equal in area.

A method of manufacturing this photoelectric conversion element will now briefly be described. Initially, as shown in Fig. 36, n-type semiconductor substrate 41 is prepared. Then, as shown in Fig. 37, while a texture mask 48 such as a silicon oxide film is formed on one surface of semiconductor substrate 41, the light-receiving surface of semiconductor substrate 41 is textured, so that the textured structure is formed at the light-receiving surface of semiconductor substrate 41.

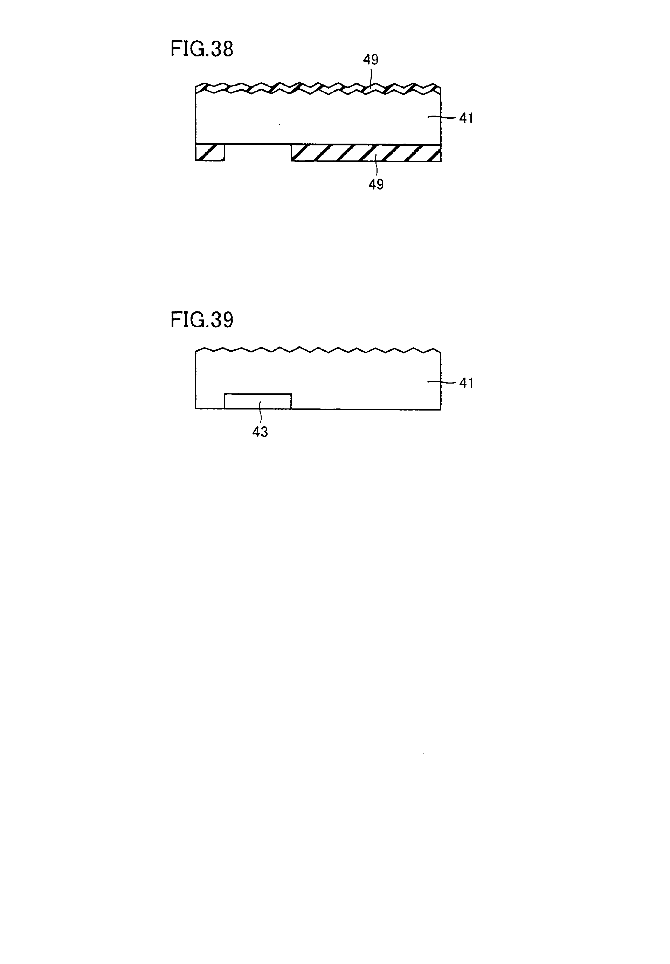

Then, as shown in Fig. 38, a first diffusion mask 49 covering the entire light-receiving surface of semiconductor substrate 41 and the back surface except for a region in the back surface where the p-type layer is to be formed is formed. Then, using this first diffusion mask 49 as a mask, a p-type impurity is introduced in the exposed region of semiconductor substrate 41, to thereby form p-type layer 43 (see Fig. 39). Thereafter, as shown in Fig. 39, first diffusion mask 49 is removed.

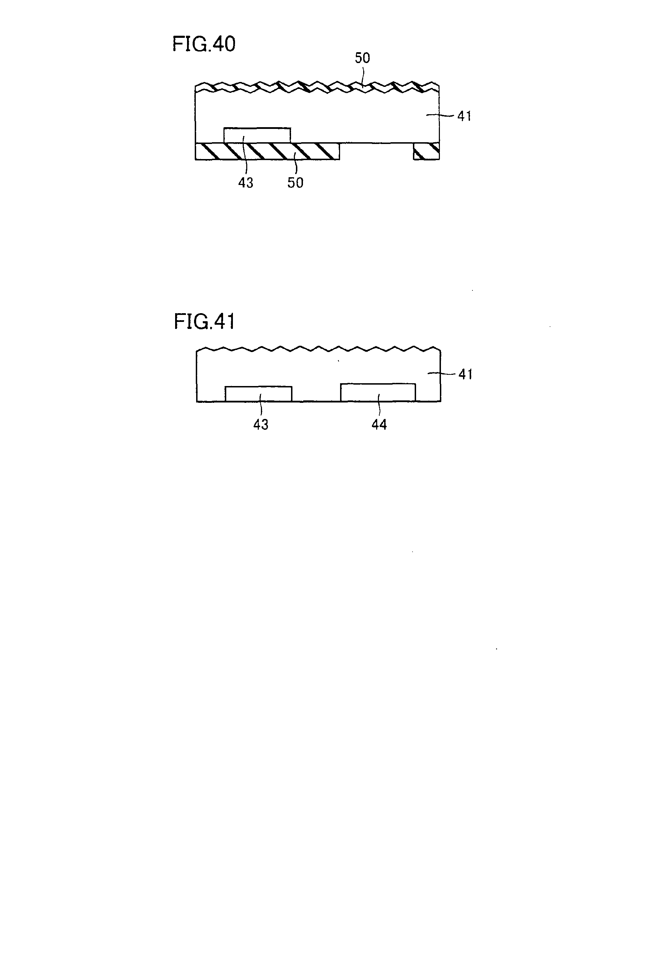

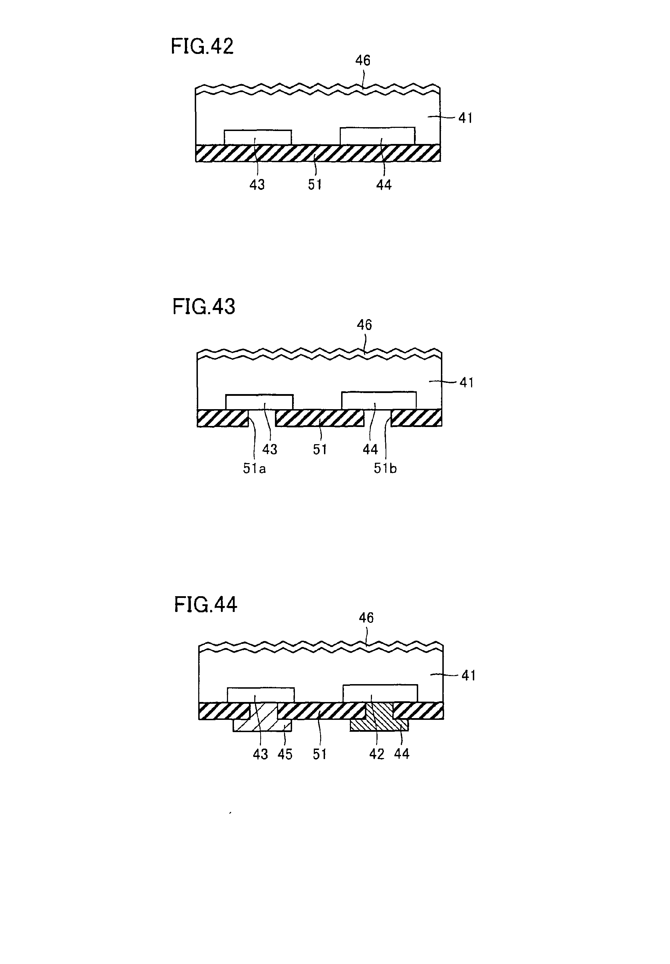

Then, as shown in Fig. 40, a second diffusion mask 50 covering the entire light-receiving surface of semiconductor substrate 41 and the back surface except for a region in the back surface where the n-type layer is to be formed is formed. Then, using this second diffusion mask 50 as a mask, an n-type impurity is introduced in the exposed region of semiconductor substrate 41, to thereby form n-type layer 44 (see Fig. 41). Thereafter, as shown in Fig. 41, second diffusion mask 50 is removed. Then, as shown in Fig. 42, a passivation film 51 such as a silicon oxide film is formed on the entire back surface of semiconductor substrate 41.

Then, as shown in Fig. 43, the passivation film is subjected to prescribed photolithography process and etching, to thereby form contact holes 51a and 51b exposing the surface of p-type layer 43 and the surface of n-type layer 42 respectively. Then, by printing a silver paste on the back surface of semiconductor substrate 41 and firing the paste at a prescribed temperature, p electrode 45 connected to p-type layer 43 and n electrode 44 connected to n-type layer 42 are formed as shown in Fig. 44. The photoelectric conversion element is thus formed.

In photoelectric conversion element 1 described above as well, by applying the present interconnector, extending portion 21 experiencing heat shrinkage is not fixed to cell substrate 11 but connection portion 21 is fixed to cell substrate 11, so that stress involved with heat shrinkage of extending portion 21 is absorbed by connection portion 22 and cell substrate 11 can be prevented from warping.

### Second Embodiment

Here, a photoelectric conversion module including the series of photoelectric conversion elements described previously will be described. As shown in Fig. 45, in a photoelectric conversion module 30, the series of photoelectric conversion elements 12 is sealed with a sealing material 32 composed of EVA (Ethylene Vinyl Acetate) resin. Sealing material 32 sealing the series of photoelectric conversion elements 12 is sandwiched between a glass plate 33 serving as a surface protection layer and a back film 31. One external terminal 35a and the other external terminal 35b of the series of photoelectric conversion elements 12 are taken out of back film 31. In addition, a frame 34 formed of an aluminum frame is attached to surround glass plate 33, sealing material 32 and back film 31 from an outer side.

An exemplary method of manufacturing photoelectric conversion module 30 will now briefly be described. Initially, the series of photoelectric conversion elements 12 is sandwiched between EVA films, which is in turn sandwiched between glass plate 33 and back film 31. Then, in such a state, a pressure in a space between glass plate 33 and back film 31 is reduced to remove bubbles. Then, as a result of heating at a prescribed temperature to cure EVA, the series of photoelectric conversion elements 12 is sealed with sealing material 32. Thereafter, photoelectric conversion module 30 is completed by attaching glass plate 33, sealing material 32 and back film 31 to frame 34 formed of the aluminum frame.

In the manufacturing method described above, in particular in the step of sealing the series of photoelectric conversion elements with the EVA resin, the EVA resin is subjected to heat treatment at a temperature of approximately 140°C followed by cooling. Therefore, stress (thermal stress) originating from difference in coefficient of thermal expansion is caused between cell substrate 11 and interconnector 20 until the temperature decreases to room temperature after heat treatment.

Meanwhile, after photoelectric conversion module 30 is installed on a roof or the like of a construction, it is repeatedly exposed to outside air at high and low temperatures. During the day, a temperature of photoelectric conversion module 30 attains to approximately 70°C as a result of irradiation with solar rays. On the other hand, during the night, the temperature of photoelectric conversion module 30 decreases to approximately 15°C or lower. The light conversion module is repeatedly exposed to outside air at such temperatures and stress originating from difference in coefficient of thermal expansion is generated between cell substrate 11 and interconnector 20 also by such temperature variation.

As described already, in the photoelectric conversion module described above, extending portion 21 of interconnector 20 experiencing heat shrinkage is not fixed to cell substrate 11 but connection portion 21 is fixed thereto, so that stress involved with heat shrinkage of extending portion 21 is absorbed by connection portion 22 and cell substrate 11 can be prevented from warping or breaking.

In the embodiment described above, a photoelectric conversion substrate in which a photoelectric conversion element main body is formed has been described by way of example of an element-formed substrate. A substrate in which an element other than the photoelectric conversion element main body is formed may be adopted as the element-formed substrate.

It should be understood that the embodiments disclosed herein are illustrative and non-restrictive. The scope of the present invention is defined by the terms of the claims, rather than the description above, and is intended to include any modifications within the scope and meaning equivalent to the terms of the claims.

### INDUSTRIAL APPLICABILITY

The present element interconnection member, photoelectric conversion element, series of photoelectric conversion elements, and photoelectric conversion module are effectively utilized in a photoelectric conversion technique.

## Claims

1. An element interconnection member for electrically connecting one element-formed substrate (11) and another element-formed substrate (11) to each other, each having a prescribed element main body (1) and a plurality of electrodes (8, 9) formed thereon, comprising:
an extending portion (21) extending in a prescribed direction based on arrangement relation of said one element-formed substrate (11) and said another element-formed substrate (11);
a first connection portion (22) formed in a comb shape so as to protrude from said extending portion (21) in another direction intersecting said prescribed direction and fixed and electrically connected to a prescribed electrode (8, 9) of said plurality of electrodes (8, 9) on said one element-formed substrate (11); and
a second connection portion (22) formed in a comb shape so as to protrude from said extending portion (21) in yet another direction intersecting said prescribed direction and fixed and electrically connected to a prescribed electrode (8, 9) of said plurality of electrodes (8, 9) on said another element-formed substrate (11).

2. The element interconnection member according to claim 1, wherein
said extending portion (21) includes a portion not fixed to said one element-formed substrate (11) and said another element-formed substrate (11).

3. The element interconnection member according to claim 1, wherein
said first connection portion (22) is fixed to said prescribed electrode (8, 9) and said second connection portion (22) is fixed to said prescribed electrode (8, 9) while a surface of said one element-formed substrate (11) where said prescribed electrode (8, 9) is formed and a surface of said another element-formed substrate (11) where said prescribed electrode (8, 9) is formed face in an identical direction.

4. The element interconnection member according to claim 1, wherein
said extending portion (21) includes
a first extending portion (23) extending in a first direction as said prescribed direction,
a second extending portion (21a) connected to said first extending portion (23) so as to extend in a second direction intersecting said first direction, as said prescribed direction, and
a third extending portion (21b) connected to said first extending portion (23) so as to extend in a third direction opposite to said second direction, as said prescribed direction,
said first connection portion (22a) is provided in said second extending portion (2 1 a), and
said second connection portion (22b) is provided in said third extending portion (21b).

5. A photoelectric conversion element, comprising:
a photoelectric conversion substrate (11) having a first main surface and a second main surface, having said first main surface as a light-receiving surface, and having a photoelectric conversion element main body (1) formed thereon;
a first electrode (8) and a second electrode (9) each formed on said second main surface of said photoelectric conversion substrate (11) as a terminal of said photoelectric conversion element main body (1); and
an element interconnection member (20) having an extending portion (21) extending in a prescribed direction and a connection portion (22) formed in a comb shape so as to protrude from said extending portion (21) in a direction intersecting said prescribed direction, said connection portion (22) being fixed to said first electrode (8).

6. A series of photoelectric conversion elements, comprising:
a plurality of photoelectric conversion substrates (11) each having a first main surface and a second main surface, each having said first main surface as a light-receiving surface, and each having a photoelectric conversion element main body (1) formed thereon;
a first electrode (8) and a second electrode (9) each formed on said second main surface of each of said plurality of photoelectric conversion substrates (11) as a terminal of said photoelectric conversion element (1); and
a plurality of element interconnection members (20) each having an extending portion (21) extending in a prescribed direction and a first connection portion (22) and a second connection portion (22) each formed in a comb shape so as to protrude from said extending portion (21) in a direction intersecting said prescribed direction, said first connection portion (22) being fixed to said first electrode (8) on one photoelectric conversion substrate and said second connection portion (22) being fixed to said second electrode (9) on another photoelectric conversion substrate adjacent to said one photoelectric conversion substrate among said plurality of photoelectric conversion substrates, thereby said plurality of photoelectric conversion substrates being electrically connected to one another.

7. The series of photoelectric conversion elements according to claim 6,
wherein
said first connection portion (22) of one element interconnection member (20) of said plurality of element interconnection members (20), that is fixed to said first electrode (8) on said one photoelectric conversion substrate (11) and said second connection portion (22) of another element interconnection member (20) of said plurality of element interconnection members (20), that is fixed to the second electrode (9) on said one photoelectric conversion substrate (11) are disposed to face each other.

8. An element interconnection member (20) for electrically connecting one element-formed substrate (11) and another element-formed substrate (11) to each other, each having a prescribed element main body (1) and a plurality of electrodes (8, 9) formed thereon, comprising:
a zigzag-shaped extending portion (21) extending in a prescribed direction based on arrangement relation of said one element-formed substrate (11) and said another element-formed substrate (11).

9. The element interconnection member according to claim 8, wherein
said extending portion (21) is in such a zigzag shape as bending a straight line.

10. The element interconnection member according to claim 8, wherein
said extending portion (21) is in a curved zigzag shape.

11. A photoelectric conversion element, comprising:
a photoelectric conversion substrate (11) having a first main surface and a second main surface, having said first main surface as a light-receiving surface, and having a photoelectric conversion element main body (1) formed thereon;
a first electrode (8) and a second electrode (9) each formed on said second main surface of said photoelectric conversion substrate (11) as a terminal of said photoelectric conversion element main body (1); and
an element interconnection member (20) having a zigzag-shaped extending portion (21) extending in a prescribed direction, a prescribed portion in said extending portion (21) being fixed to said first electrode (8).

12. A series of photoelectric conversion elements, comprising:
a plurality of photoelectric conversion substrates (11) each having a first main surface and a second main surface, each having said first main surface as a light-receiving surface, and each having a photoelectric conversion element main body (1) formed thereon;
a first electrode (8) and a second electrode (9) each formed on said second main surface of each of said plurality of photoelectric conversion substrates (11) as a terminal of said photoelectric conversion element (1); and
a plurality of element interconnection members (20) each having a zigzag-shaped extending portion (21) extending in a prescribed direction, a prescribed portion of said extending portion (21) being fixed to said first electrode (8, 9) on one photoelectric conversion substrate (11) and another prescribed portion of said extending portion (21) being fixed to said second electrode (8, 9) on another photoelectric conversion substrate (11) adjacent to said one photoelectric conversion substrate (11) among said plurality of photoelectric conversion substrates (11), thereby said plurality of photoelectric conversion substrates (11) being electrically connected to one another.

13. A photoelectric conversion module, comprising the series of photoelectric conversion elements (12) according to any of claims 6, 7 and 12.
